# EUROPEAN PATENT APPLICATION

(11) **EP 4 465 356 A1**
(43) Date of publication of application: **20.11.2024**
(21) Application number: 22948526.3
(22) Date of filing: 30.06.2022
(51) Int. Cl.: H01L 27/00

(54) **DISPLAY SUBSTRATE AND DISPLAY APPARATUS**

(71) Applicant: Boe Technology Group Co., Ltd., Beijing 100015 (CN); Beijing BOE Technology Development Co., Ltd., Beijing 100176 (CN)
(72) Inventor: WANG, Hongli, Beijing 100176 (CN); XU, Jian, Beijing 100176 (CN); BAI, Jinglu, Beijing 100176 (CN); ZHAO, Dejiang, Beijing 100176 (CN)
(74) Representative: Maiwald GmbH
(86) International application number: PCT/CN2022/102867
(87) International publication number: WO 2024/000421

(57) **Abstract**

A display substrate and a display apparatus. The display apparatus comprises a base substrate and, disposed on the base substrate, a plurality of light-emitting elements and a pixel defining pattern. The light-emitting elements comprise a light-emitting functional layer, a first electrode and a second electrode; the pixel defining pattern comprises a plurality of openings and a defining part surrounding the plurality of openings, and the light-emitting elements are at least partially located in the openings. The light-emitting elements further comprise a optical conversion layer, the optical conversion layer being configured to cause one color of light incident upon the optical conversion layer to then be emitted as a different color of light; the optical conversion layer is located on the side of the second electrode away from the base substrate, and the optical conversion layer is at least partially located in the openings; the surface, closest to the base substrate, of the part of the optical conversion layer located in the openings is closer to the base substrate than at least a portion of the surface, furthest from the base substrate, of the defining part. The display substrate provided by the embodiments of the present disclosure reduces to the extent possible the distance between the optical conversion layer and the light-emitting functional layer, so as to improve the conversion efficiency of incident light by the optical conversion layer.

## Description

### TECHNICAL FIELD

Embodiments of the present disclosure relate to a display substrate and a display apparatus.

### BACKGROUND

Organic light emitting diode display panels have received wide attention for their lightness and thinness, bendability, brilliant colors, high contrast ratios, high response rates, and other advantages, and are gradually replacing liquid crystal display panels. Quantum dot materials, for example, red quantum dot materials and green quantum dot materials, may be disposed in an organic light emitting diode display panel. The quantum dot materials can be used to implement a display apparatus with high color purity.

### SUMMARY

Embodiments of the present disclosure provide a display substrate and a display apparatus.

An embodiment of the present disclosure provides a display substrate, which includes a base substrate, and a plurality of light emitting elements and a pixel defining pattern on the base substrate. The light emitting element includes a light emitting functional layer, and a first electrode and a second electrode that are located on two sides of the light emitting functional layer in a direction perpendicular to the base substrate, and the first electrode is located between the light emitting functional layer and the base substrate; the pixel defining pattern is located on a side of the first electrode away from the base substrate, the pixel defining pattern includes a plurality of openings and a defining portion that surrounds the plurality of openings, and the light emitting elements are at least partially located in the openings. At least one light emitting element further includes an optical conversion layer, the optical conversion layer is configured such that light of one color is incident to the optical conversion layer and then exits light of another color, the optical conversion layer is located on a side of the second electrode away from the base substrate, and at least a part of the optical conversion layer is located in the opening, and the optical conversion layer has a part in the opening, a surface, of the part of the optical conversion layer, close to the base substrate is closer to the base substrate than a surface, of at least one part of the defining portion, away from the base substrate.

For example, according to an embodiment of the present disclosure, a surface, of the part of the optical conversion layer, away from the base substrate is closer to the base substrate than the surface, of the at least one part of the defining portion, away from the base substrate.

For example, according to an embodiment of the present disclosure, a surface, of the part of the optical conversion layer, away from the base substrate includes a central part and an edge part, the central part is closer to the base substrate than the edge part.

For example, according to an embodiment of the present disclosure, the optical conversion layer includes quantum dots.

For example, the display substrate further includes: a first insulation layer, located between the optical conversion layer and the second electrode, wherein the first insulation layer has a part located in the opening, a surface, of the part of the first insulation layer, away from the base substrate is closer to the base substrate than the surface, of the at least one part of the defining portion, away from the base substrate.

For example, according to an embodiment of the present disclosure, a thickness of the first insulation layer is less than a thickness of the at least one part of the defining portion.

For example, according to an embodiment of the present disclosure, the first insulation layer includes at least two film layers, and a difference between thicknesses of different film layers is less than one micron.

For example, according to an embodiment of the present disclosure, the plurality of light emitting elements includes light emitting elements of at least two colors, the defining portion located between openings corresponding to adjacent light emitting elements of different colors includes a first sub-defining portion, the defining portion located between openings corresponding to adjacent light emitting elements of a same color includes a second sub-defining portion, a maximum thickness of the first sub-defining portion is greater than a maximum thickness of the second sub-defining portion, and/or, a surface of the first sub-defining portion away from the base substrate includes a first slope, a surface of the second sub-defining portion away from the base substrate includes a second slope, and a slope angle of the first slope is greater than a slope angle of the second slope; and a part of the second electrode covering the second sub-defining portion is continuously disposed.

For example, the display substrate further includes: a signal transmission line, located on a side of the first electrode facing the base substrate; and a transmission portion, located on the side of the first electrode facing the base substrate, and electrically connected to the signal transmission line. The display substrate includes a display region and a peripheral region that surrounds the display region, the signal transmission line is located in the peripheral region, the transmission portion is located on a side that is of a part on an utmost edge in the defining portion and that is close to the display region, and the second electrode is electrically connected to the transmission portion.

For example, according to an embodiment of the present disclosure, at least two adjacent light emitting elements arranged in a first direction emit light of a same color, and at least two adjacent light emitting elements arranged in a second direction emit light of different colors, and the first direction intersects with the second direction; and the defining portion includes a plurality of first sub-defining portions and a plurality of second sub-defining portions, at least one of the first sub-defining portions extends in the first direction, and the second sub-defining portion extending in the second direction is disposed between two adjacent first sub-defining portions.

For example, according to an embodiment of the present disclosure, the display substrate further includes: an electrode overlapping portion, located on a side of the defining portion facing the base substrate, wherein the defining portion overlaps the electrode overlapping portion in a direction perpendicular to the base substrate. The defining portion includes a hole or a slot exposing the electrode overlapping portion, and the second electrode is electrically connected to the electrode overlapping portion via the hole or the slot.

For example, according to an embodiment of the present disclosure, a ratio of a maximum thickness of the defining portion between light emitting elements that emit light of different colors to a maximum thickness of the defining portion between light emitting elements that emit light of a same color is 0.8 to 1.

For example, according to an embodiment of the present disclosure, at least one part of the electrode overlapping portion and at least one part of the defining portion extend in a same direction.

For example, according to an embodiment of the present disclosure, the display substrate further includes: a signal transmission line, located on a side of the first electrode facing the base substrate, wherein the display substrate includes a display region and a peripheral region that surrounds the display region, the signal transmission line is located in the peripheral region, and the second electrode is electrically connected to the signal transmission line by using the electrode overlapping portion.

For example, according to an embodiment of the present disclosure, the electrode overlapping portion includes at least one film layer disposed at the same layer as the first electrode.

For example, according to an embodiment of the present disclosure, the electrode overlapping portion includes a plurality of film layers, and a distance between a surface of the electrode overlapping portion away from the base substrate and the base substrate is greater than a distance between a surface of the first electrode away from the base substrate and the base substrate.

For example, according to an embodiment of the present disclosure, the electrode overlapping portion includes a film layer located on the side of the first electrode away from the base substrate.

For example, according to an embodiment of the present disclosure, the display substrate further includes: a planarization layer, located between the first electrode and the base substrate. The planarization layer includes a planarization layer convex portion, and an orthographic projection of the planarization layer convex portion on the base substrate overlaps an orthographic projection of the electrode overlapping portion on the base substrate, so that a distance between a surface of the electrode overlapping portion away from the base substrate and the base substrate is greater than a distance between a surface of the first electrode away from the base substrate and the base substrate.

For example, according to an embodiment of the present disclosure, the display substrate further includes: a planarization layer, located between the first electrode and the base substrate. The planarization layer includes a groove, and the defining portion does not overlap the groove in the direction perpendicular to the base substrate; and the first electrode and the light emitting functional layer of at least some of the light emitting elements are located in the groove, and at least one part of a surface of the light emitting functional layer away from the base substrate is closer to the base substrate than a surface of the electrode overlapping portion away from the base substrate.

For example, according to an embodiment of the present disclosure, the display substrate further includes: a transparent compensation structure, located between the optical conversion layer and a bottom of the groove.

For example, according to an embodiment of the present disclosure, a side wall of the groove is obliquely disposed, and the side wall includes a part away from the base substrate and a part close to the base substrate, the part away from the base substrate is farther away from a center of a light emitting region of the light emitting element disposed in the groove than the part close to the base substrate.

For example, according to an embodiment of the present disclosure, the defining portion includes the hole, the plurality of light emitting elements includes light emitting elements of at least two different colors, and among a spacing between light emitting regions of adjacent light emitting elements with different colors and a spacing between adjacent light emitting elements with a same color, at least the spacing with a largest size is provided with the hole.

For example, according to an embodiment of the present disclosure, the display substrate further includes: an isolation structure, located between the second electrode and the defining portion. The isolation structure overlaps the defining portion in the direction perpendicular to the base substrate, and a material of the isolation structure is different from a material of the defining portion; and in an arrangement direction of adjacent light emitting elements, an edge, of the isolation structure located between the adjacent light emitting elements, protrudes relative to an edge of the defining portion to form a convex portion.

For example, according to an embodiment of the present disclosure, the display substrate further includes: a spacer, located on a surface of at least one part in the defining portion away from the base substrate.

For example, according to an embodiment of the present disclosure, the defining portion includes a first defining portion and a second defining portion that are stacked, the first defining portion is located on a side of the second defining portion close to the base substrate, and a surface of the optical conversion layer close to the base substrate is closer to the base substrate than a surface of at least one part of the second defining portion away from the base substrate.

For example, according to an embodiment of the present disclosure, the first defining portion is in direct contact with the second defining portion; or, the display substrate further includes a first insulation layer, located between the optical conversion layer and the second electrode, wherein the first insulation layer is disposed between the first defining portion and the second defining portion.

For example, according to an embodiment of the present disclosure, a cross section of the defining portion cut by a plane is a defining portion cross section, the plane is a plane where a line connecting centers of light emitting regions of two adjacent light emitting elements located on both sides of the defining portion is located, a shape of the defining portion cross section includes a trapezium or a step shape, and the plane is perpendicular to the base substrate.

For example, according to an embodiment of the present disclosure, a cross section of the defining portion cut by a plane is a defining portion cross section, the plane is a plane where a line connecting centers of light emitting regions of two adjacent light emitting elements located on both sides of the defining portion is located, the defining portion cross section includes a middle part and two side parts, in a direction parallel to the base substrate, a size of the middle part is greater than or less than sizes of the two side parts, and the plane is perpendicular to the base substrate.

For example, according to an embodiment of the present disclosure, the defining portion includes at least two layers of structures that are stacked.

For example, according to an embodiment of the present disclosure, the light emitting functional layer includes a thermally activated delayed fluorescent material.

For example, according to an embodiment of the present disclosure, the plurality of light emitting elements includes light emitting elements of at least two colors, the light emitting functional layers of the light emitting elements of the at least two colors are configured to both emit first color light, and the light emitting element of at least one color in the light emitting elements of the at least two colors includes the optical conversion layer, and the first color light is converted to second color light after passing through the optical conversion layer.

For example, according to an embodiment of the present disclosure, the display substrate further includes: a second insulation layer, located on a side of the optical conversion layer away from the base substrate; and a color film layer, located on a side of the second insulation layer away from the optical conversion layer.

For example, according to an embodiment of the present disclosure, the second insulation layer includes refractive particles.

In the display substrate provided in embodiments of the present disclosure, the surface, of the optical conversion layer, close to the base substrate is disposed closer to the base substrate than a surface, of at least one part of the defining portion, away from the base substrate, so as to minimize a distance between the optical conversion layer and the light emitting functional layer, thereby improving conversion efficiency of the optical conversion layer for incident light.

An embodiment of the present disclosure provides a display substrate, including: a base substrate, and a plurality of light emitting elements and a pixel defining pattern on the base substrate. The light emitting element includes a light emitting functional layer, and a first electrode and a second electrode that are located on two sides of the light emitting functional layer in a direction perpendicular to the base substrate, and the first electrode is located between the light emitting functional layer and the base substrate; the pixel defining pattern is located on a side of the first electrode away from the base substrate, the pixel defining pattern includes a plurality of openings and a defining portion that surrounds the plurality of openings, and the light emitting element is at least partially located in the opening. At least one of the light emitting elements further includes an optical conversion layer, the optical conversion layer is configured such that light of one color is incident to the optical conversion layer and then exits light of another color, and the optical conversion layer is located on a side of the first electrode away from the second electrode.

In the display substrate provided in the embodiment of the present disclosure, the optical conversion layer is disposed a side of the first electrode away from the second electrode, so as to minimize a distance between the optical conversion layer and the light emitting functional layer, thereby improving conversion efficiency of the optical conversion layer for incident light.

An embodiment of the present disclosure provides a display apparatus, including the display substrate in any embodiment as mentioned above and an opposing substrate disposed opposite to the display substrate. The opposing substrate is located on a display side of the display substrate.

For example, according to an embodiment of the present disclosure, a material layer is disposed on a side of the opposing substrate facing the display substrate and at a position directly opposite the optical conversion layer, and the material layer includes the same material as that in the optical conversion layer.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1A is a schematic diagram of a partial planar structure of a display substrate according to an example of an embodiment of the present disclosure.
Fig. 1B is a schematic diagram of a partial planar structure of a display substrate according to an example of an embodiment of the present disclosure.
Fig. 2 is a schematic diagram of a partial cross-sectional structure cut along line AA' shown in Fig. 1A.
Fig. 3 is a schematic diagram of a partial cross-sectional structure cut along line BB' shown in Fig. 1A according to an example of an embodiment of the present disclosure.
Fig. 4A is a schematic diagram of a partial cross-sectional structure cut along line CC' shown in Fig. 1A.
Fig. 4B is a schematic diagram of a partial cross-sectional structure cut along C1C1' shown in Fig. 1B.
Fig. 5 is a schematic diagram of a partial cross-sectional structure cut along line DD' shown in Fig. 1A according to another example of an embodiment of the present disclosure.
Fig. 6 is a schematic diagram of a partial planar structure of a display substrate according to another example of an embodiment of the present disclosure.
Fig. 7 is a schematic diagram of a partial cross-sectional structure cut along line EE' shown in Fig. 6.
Fig. 8A is a schematic diagram of a partial cross-sectional structure cut along line FF' shown in Fig. 6.
Fig. 8B is a partial enlarged schematic diagram of an F1 region shown in Fig. 8A.
Fig. 9 is a schematic diagram of a partial cross-sectional structure cut along line EE' shown in Fig. 6 according to another example of an embodiment of the present disclosure.
Fig. 10 is a schematic diagram of a partial cross-sectional structure cut along line EE' shown in Fig. 6 according to another example of an embodiment of the present disclosure.
Fig. 11 is a schematic diagram of a partial cross-sectional structure cut along line EE' shown in Fig. 6 according to another example of an embodiment of the present disclosure.
Fig. 12 is a schematic diagram of a partial cross-sectional structure cut along line EE' shown in Fig. 6 according to another example of an embodiment of the present disclosure.
Fig. 13 is a schematic diagram of a partial cross-sectional structure cut along line EE' shown in Fig. 6 according to another example of an embodiment of the present disclosure.
Fig. 14 and Fig. 15 are schematic diagrams of partial cross-sectional structures cut along line EE' shown in Fig. 6 according to different examples of an embodiment of the present disclosure.
Fig. 16 to Fig. 17B are schematic diagrams of partial planar structures of display substrates according to different examples of an embodiment of the present disclosure.
Fig. 18 is a schematic diagram of a partial cross-sectional structure cut along line AA' shown in Fig. 1A according to another example of an embodiment of the present disclosure.
Fig. 19 is a schematic diagram of a partial cross-sectional structure cut along line AA' shown in Fig. 1A according to another example of an embodiment of the present disclosure.
Fig. 20 is a schematic diagram of a partial cross-sectional structure cut along line AA' shown in Fig. 1A according to another example of an embodiment of the present disclosure.
Fig. 21 is a schematic diagram of a partial cross-sectional structure cut along line AA' shown in Fig. 1A according to another example of an embodiment of the present disclosure.
Fig. 22 to Fig. 26 are schematic diagrams of partial cross-sectional structures of defining portions in display substrates according to different examples.
Fig. 27 is a schematic diagram of a partial cross-sectional structure cut along line AA' shown in Fig. 1A according to another example of an embodiment of the present disclosure.
Fig. 28 is a schematic diagram of a partial cross-sectional structure cut along line AA' shown in Fig. 1A according to another example of an embodiment of the present disclosure.
Fig. 29 shows a display substrate according to another embodiment of the present disclosure.
Fig. 30 is a schematic diagram of a partial cross-sectional structure of a display apparatus according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects.

Features such as "parallel", "perpendicular" and "identical", etc. used in the embodiments of the present disclosure all include strictly defined features such as "parallel", "perpendicular" and "identical", as well as cases where certain errors are included such as "substantially parallel", "substantially perpendicular" and "substantially identical", considering that errors related to measurement and measurement of a specific quantity (e.g., limitations of a measurement system) indicate that such features are within an acceptable deviation range for a specific value determined by those ordinarily skilled in the art. For example, the expression "substantially" may indicate that features are within one or more standard deviations, or within 10% or 5% of a value. When a quantity of a component is not specifically specified in the following text of the embodiments of the present disclosure, it means that the quantity of such component may be one or more, or may be understood as at least one. The expression "at least one" refers to one or more, and "more" refers to at least two. "Same layer" in the embodiment of the present disclosure refers to the relationship between multiple film layers formed by the same material after the same step (for example, one-step patterning process). The "same layer" here does not always mean that thicknesses of the multiple film layers are the same or heights of the multiple film layers in cross section are the same.

Embodiments of the present disclosure provide a display substrate and a display apparatus. The display apparatus includes a base substrate and a plurality of light emitting elements and a pixel defining pattern located on the base substrate. The light emitting element includes a light emitting functional layer and a first electrode and a second electrode that are located on two sides of the light emitting functional layer in a direction perpendicular to the base substrate, and the first electrode is located between the light emitting functional layer and the base substrate. The pixel defining pattern is located on a side of the first electrode away from the base substrate, and includes a plurality of openings and a defining portion surrounding the plurality of openings, and the light emitting elements are at least partially located in the openings. At least one of the light emitting elements further includes an optical conversion layer, the optical conversion layer is configured such that light of one color is incident to the optical conversion layer and then exits light of another color, the optical conversion layer is located on a side of the second electrode away from the base substrate, and at least a part of the optical conversion layer is located in the opening, and the optical conversion layer has a part in the opening, a surface, of the part of the optical conversion layer, close to the base substrate is closer to the base substrate than a surface, of at least one part of the defining portion, away from the base substrate. In the display substrate provided in embodiments of the present disclosure, the surface, of the part of the optical conversion layer, close to the base substrate is disposed closer to the base substrate than a surface that is of at least one part of the defining portion away from the base substrate, so as to minimize a distance between the optical conversion layer and the light emitting functional layer, thereby improving conversion efficiency of the optical conversion layer for incident light.

Hereinafter, the display substrate and the display apparatus provided by the embodiments of the present disclosure will be described in conjunction with the accompanying drawings.

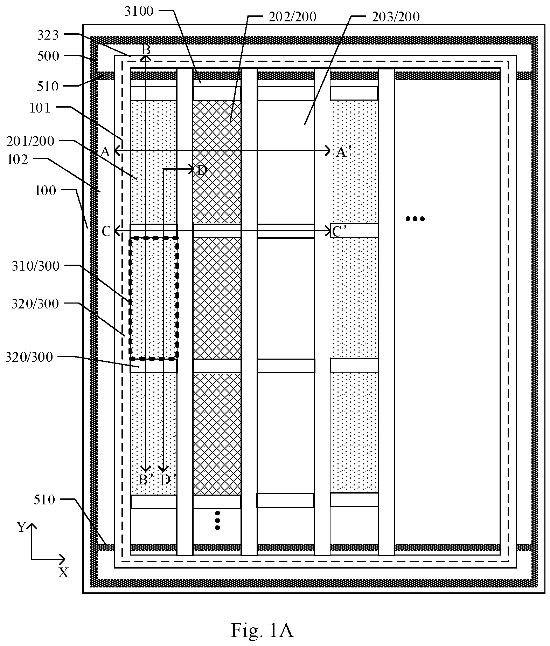

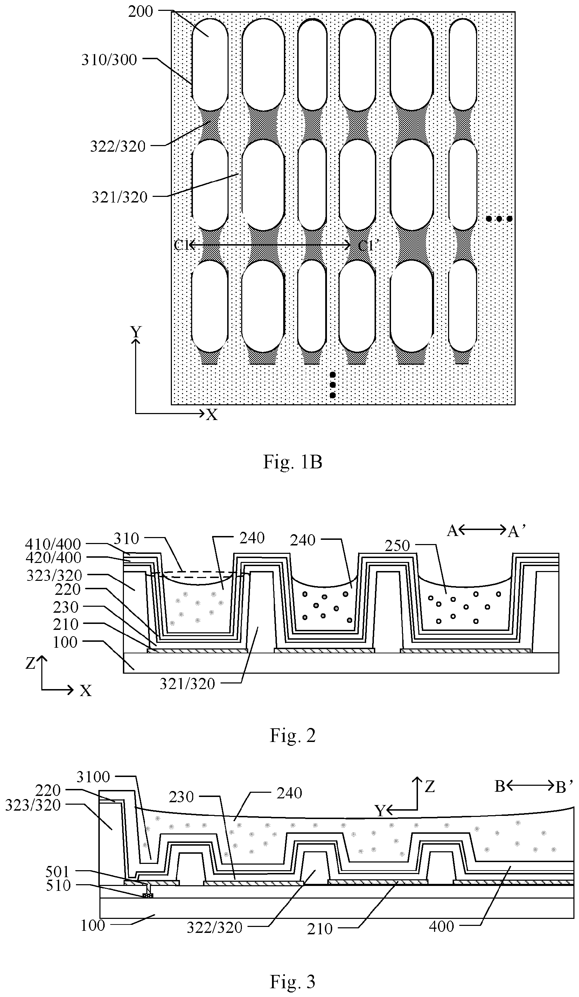

Fig. 1A is a schematic diagram of a partial planar structure of a display substrate according to an example of an embodiment of the present disclosure. Fig. 2 is a schematic diagram of a partial cross-sectional structure cut along line AA' shown in Fig. 1A.

As shown in Fig. 1A and Fig. 2, the display substrate includes a base substrate 100 and a plurality of light emitting elements 200 and a pixel defining pattern 300 that are located on the base substrate 100. The light emitting element 200 includes a light emitting functional layer 230 and a first electrode 210 and a second electrode 220 that are located on two sides of the light emitting functional layer in a direction perpendicular to the base substrate 100, and the first electrode 210 is located between the light emitting functional layer 230 and the base substrate 100. The foregoing direction perpendicular to the base substrate 100 is a direction perpendicular to a mainboard that is provided with the light emitting element 200 and that is of the base substrate 100, for example, the Z direction shown in Fig. 2.

As shown in Fig. 1A and Fig. 2, the pixel defining pattern 300 is located on a side of the first electrode 210 away from the base substrate 100. The pixel defining pattern 300 includes a plurality of openings 310 and a defining portion 320 that surrounds the plurality of openings 310, and the light emitting elements 200 are at least partially located in the openings 310. For example, the defining portion 320 may be formed of a transparent material, or may be formed of a black material. That the light emitting elements are at least partially located in the opening means that at least one part of each light emitting element is located in the opening.

As shown in Fig. 1A and Fig. 2, at least one of the light emitting elements 200 further includes an optical conversion layer 240, the optical conversion layer 240 is configured such that light of one color is incident to the optical conversion layer 240 and then exits light of another color, the optical conversion layer 240 has a part in the opening 310, a surface, of the part of the optical conversion layer 240, close to the base substrate 100 is closer to the base substrate 100 than a surface that is of at least one part of the defining portion 320 away from the base substrate 100.

In the display substrate provided in this embodiment of the present disclosure, the surface that is of the optical conversion layer and that is close to the base substrate is disposed closer to the base substrate than the surface that is of the at least one part of the defining portion away from the base substrate, so as to minimize a distance between the optical conversion layer and the light emitting functional layer, thereby improving conversion efficiency of the optical conversion layer for incident light.

Fig. 1A only schematically shows the pixel defining pattern, and a profile of a light emitting element defined by an opening of the pixel defining pattern, and does not specifically show a film layer on a side of the pixel defining pattern away from the base substrate, and a film layer in the light emitting element.

The surface of the defining portion away from the base substrate is a surface at a position of the defining portion farthest away from the base substrate. The surface may be plane, or an arc-shaped surface. The surface does not include a side surface of the defining portion.

The optical conversion layer in the display substrate provided in the present disclosure is not a film layer of an entire layer, and the optical conversion layer is a film layer located in the opening of the pixel defining pattern. Certainly, this embodiment of the present disclosure is not limited thereto. In addition to the part located in the opening, the optical conversion layer may further include a part located in a surface of at least one part of the defining portion (for example, a second sub-defining portion described below) away from the base substrate, but optical conversion layers of light emitting elements of different colors are disposed with a spacing therebetween, and there is no contact.

For example, as shown in Fig. 2, the defining portion 320 may be an integrated structure in a direction perpendicular to the base substrate 100. For example, the defining portion 320 includes only one layer.

For example, the defining portion 320 may include a part located between light emitting elements 200 that emit light of a same color and a part located between light emitting element 200 that emit light of different colors. The at least one part of the defining portion 320 may be the part located between the light emitting elements 200 that emit light of different colors, or may be the part located between the light emitting elements 200 that emit light of the same color, or each position of the defining portion 320.

For example, as shown in Fig. 2, a plane parallel to the base substrate 100 runs through the at least one part of the defining portion 320 and the optical conversion layer 240. For example, the optical conversion layer 240 and the at least one part of the defining portion 320 are disposed in an overlapping manner in a direction parallel to the base substrate 100. For example, an orthographic projection of the optical conversion layer 240 in a plane perpendicular to the base substrate 100 overlaps an orthographic projection of the at least one part of the defining portion 320 in the plane.

For example, the light emitting element 200 may be an organic light emitting diode. For example, the light emitting element 200 may be an organic light emitting element. For example, the light emitting element 200 may be an electroluminescent element. For example, the light emitting element 200 may correspond to a subpixel on the display substrate. For example, one subpixel includes one light emitting element, or one subpixel includes two or more light emitting elements.

For example, the light emitting functional layer 230 includes a plurality of film layers. For example, the plurality of film layers may include a hole injection layer (HIL), a hole transport layer (HTL), an light-emitting layer (EL), an electron transport layer (ETL), an electron injection layer (EIL), and other film layers. For example, the light emitting functional layer 230 may further include a hole blocking layer (HBL), an electron blocking layer (EBL), a microcavity adjustment layer, an exciton adjustment layer, or another functional film layer. For example, the hole injection layer and the hole transport layer are located between the light-emitting layer and the first electrode 210, and the electron transport layer and the electron injection layer are located between the light-emitting layer and the second electrode 220. For example, the hole blocking layer is located between the light-emitting layer and the second electrode 220. For example, the electron blocking layer is located between the light-emitting layer and the first electrode 210. For example, the light-emitting functional layer may further include a plurality of stacked components, such as a first stack layer including a first light-emitting layer, and a second stack layer including a second light-emitting layer. The first stack layer and the second stack layer may further include one or more of: a hole injection layer (HIL), a hole transport layer (HTL), an light-emitting layer (EL), an electron transport layer (ETL) and an electron injection layer (EIL), a hole blocking layer, an electron blocking layer, a microcavity adjustment layer, an exciton adjustment layer, and other functional film layers. A charge generation layer (CGL) may be included between the first stack layer and the second stack layer. The charge generation layer (CGL) may include an n-doped charge generation layer (CGL), and/or a p-doped charge generation layer (CGL). Certainly, to further improve luminescence efficiency, the light emitting functional layer may further include three stack layers or more stack layers.

For example, the plurality of light emitting elements 200 includes some light emitting elements 200 that emit light of a same color and some light emitting elements 200 that emit light of different colors, and the light emitting elements 200 that emit light of the same color and the light emitting elements 200 that emit light of different colors may share the second electrode 220 and the light emitting functional layer 230, and the light emitting functional layer 230 may be a common layer, and the second electrode 220 may also be a common layer.

For example, the light emitting functional layer 230 of the light emitting elements 200 that emit light of different colors is configured to emit light of a same color. For example, the plurality of light emitting elements 200 includes a red light emitting element 201 configured to emit red light, a green light emitting element 202 configured to emit green light, and a blue light emitting element 203 configured to emit blue light. For example, the light emitting functional layer of the red light emitting element 201, the light emitting functional layer of the green light emitting element 202, and the light emitting functional layer of the blue light emitting element 203 all emit light of the same color.

For example, the light emitting functional layer 230 of each light emitting element 200 may include a plurality of light-emitting layers, such as a plurality of light-emitting layers that emits a same band of blue light, or a plurality of light-emitting layers that emits different bands of blue light (for example, dark blue light and light blue light), or a plurality of light-emitting layers that emits blue light and green light respectively.

For example, the light emitting functional layer 230 may include three blue light light-emitting layers and one green light light-emitting layer, where the green light light-emitting layer is disposed on a side of the three blue light light-emitting layers away from the base substrate. For example, an electron transport layer, a charge generation layer, and a hole transport layer may be provided in sequence in a stacked manner between two adjacent blue light light-emitting layers. For example, an electron transport layer, a charge generation layer, and a hole transport layer may be provided in sequence in a stacked manner between the blue light light-emitting layers and the green light light-emitting layer. For example, the green light light-emitting layer may be doped with platinum (Pt). For example, the charge generation layer located between the electron transport layer and the hole transport layer may include an n-type charge generation layer and a p-type charge generation layer. A functional layer may be added between the n-type charge generation layer and the p-type charge generation layer, to adjust carrier transport efficiency.

In some examples, the light emitting functional layer 230 includes a thermally activated delayed fluorescent (TADF) material, to improve luminescence efficiency of the light emitting functional layer, and reduce the quantity of stacked light-emitting layers, thereby reducing power consumption.

For example, a thickness of the electron transport layer may be 1 to 10 nanometers, for example, 2 to 8 nanometers or 3 to 7 nanometers. For example, a thickness of the electron injection layer may be 5 to 30 nanometers, for example, 22 to 28 nanometers, 25 to 27 nanometers, 5 to 15 nanometers, or 6 to 12 nanometers.

For example, the first electrode 210 may be an anode and the second electrode 220 may be a cathode. For example, the cathode may be formed of a material with high electrical conductivity and a low work function, for example, the cathode may be made of a metallic material. For example, the anode may be formed of an electrically conductive material having a high work function.

For example, at least one of the first electrode 210 and the second electrode 220 may include a plurality of film layers. For example, the first electrode 210 may include three film layers, that is, a first electrode layer, a second electrode layer, and a third electrode layer. For example, the first electrode 210 includes a stack layer of tungsten oxide (WOx) and aluminum (Al). For example, materials of the first electrode layer and the third electrode layer may include tungsten oxide (WOx), and a material of the second electrode layer may include aluminum (Al).

For example, the first electrode 210 includes three stack layers: indium tin oxide (ITO), silver (Ag), and indium tin oxide (ITO). For example, the first electrode 210 includes two stack layers: indium tin oxide (ITO) and silver (Ag). For example, the first electrode 210 includes indium tin oxide (ITO), silver (Ag), and other metal oxide layers (for example, WOx). For example, at least two of the two or three stack layers included in the first electrode are connected through via holes. For example, there is an insulation layer between a first sublayer and a second sublayer on a side of the first electrode close to the light-emitting layer, and the first sublayer is connected to the second sublayer through a via hole in the insulation layer, that is, the first electrode may include the first sublayer, the insulation layer, and the second sublayer. For example, the first electrode may include a first sublayer, an insulation layer, a second sublayer, and a third sublayer on a side of the second sublayer away from the insulation layer. For example, the first electrode includes a first sublayer, a second sublayer, and a third sublayer in a direction from a side close to the light-emitting layer to a side away from the light-emitting layer. There is an insulation layer between the second sublayer and the third sublayer, and the second sublayer is connected to the third sublayer through a via hole in the insulation layer, that is, the first electrode may include the first sublayer, the second sublayer, the insulation layer, and the third sublayer.

For example, the second electrode 220 may include one or two film layers. For example, the second electrode 220 may include a magnesium-silver alloy. For example, the second electrode 220 may include a first electrode layer and a second electrode layer, the first electrode layer is located on a side of the second electrode layer close to the light-emitting layer. For example, the second electrode 220 may include a stack layer of indium oxide (InOx), and silver (Ag) or a silver alloy. For example, the material of the first electrode layer may include indium oxide (InOx), and a material of the second electrode layer may include silver (Ag) or a silver alloy.

For example, the first electrode 210 is a reflective electrode, and the second electrode 220 is a transparent electrode. For example, light emitted from the light emitting functional layer 230 may be exited from a side of the second electrode 220 away from the first electrode 210, and passes through the optical conversion layer 240 to be converted into light of another color.

For example, the defining portion 320 of the pixel defining pattern 300 is a structure that defines the opening 310. For example, a material of the defining portion 320 may include polyimide, acrylic, polyethylene terephthalate, or the like. For example, the defining portion 320 includes intersecting parts to define the openings 310.

For example, the opening 310 of the pixel defining pattern 300 is configured to define a light emitting region of the light emitting element 200. For example, the plurality of light emitting elements 200 may be disposed in a one-to-one correspondence with the plurality of openings 310. For example, the light emitting element 200 may include a part located in the opening 310, and a part overlapping the defining portion 320 in the direction perpendicular to the base substrate 100.

For example, at least one part of the light emitting element 200 is located in the opening 310. For example, the first electrode 210 of the light emitting element is located on a side of the defining portion 320 close to the base substrate 100, and the opening 310 is configured to expose the first electrode 210, where at least a part of the exposed first electrode 210 is in contact with the light emitting functional layer 230 in the light emitting element 200. For example, at least one part of the first electrode 210 is located between the defining portion 320 and the base substrate 100. For example, when the light emitting functional layer 230 is located in the opening 310 of the pixel defining pattern 300, the first electrode 210 and the second electrode 220 located on two sides of the light emitting functional layer 230 can drive the light emitting functional layer 230 in the opening 310 of the pixel defining pattern 300 to emit light. For example, the light emitting region described above may be a region in which the light emitting element effectively emits light, and a shape of the light emitting region is a two-dimensional shape, for example, the shape of the light emitting region may be the same as the shape of the opening 310 of the pixel defining pattern 300. For example, the opening of the pixel defining pattern 300 may be shaped with a small size on a side close to the base substrate and a large size on a side away from the base substrate. For example, the size and the shape of the light emitting region may be approximately the same as the size and the shape of a side of the opening of the pixel defining pattern 300 close to the base substrate.

For example, at least one part of the opening 310 defined by the defining portion 320 is configured to define a light exit region of the optical conversion layer 240.

In some examples, as shown in Fig. 1A and Fig. 2, the plurality of light emitting elements 200 includes light emitting elements 200 emitting light of at least two colors, such as a first light emitting element 201 and a second light emitting element 202. Light emitting functional layers 230 of the light emitting elements 200 emitting light of the at least two colors are configured to both emit first color light, and the light emitting element 200 emitting light of at least one color in the light emitting elements 200 emitting light of the at least two colors includes the optical conversion layer 240, and the first color light is converted to second color light after passing through the optical conversion layer 240. For example, a wavelength of the first color light is less than a wavelength of the second color light.

For example, areas of light emitting regions of light emitting elements of different colors are different. For example, an area of a light emitting region of a blue light emitting element may be greater than an area of a light emitting region of at least one of a red light emitting element and a green light emitting element.

For example, one of the first light emitting element 201 and the second light emitting element 202 may be the blue light emitting element, the green light emitting element, or the red light emitting element, and the other of the first light emitting element 201 and the second light emitting element 202 may be the green light emitting element, the red light emitting element, or the blue light emitting element.

For example, the first color light may be blue light and the second color light may be red or green light.

For example, as shown in Fig. 2, the at least two light emitting elements 200 that emit light of different colors include the optical conversion layer 240. For example, the red light emitting element and the green light emitting element may both include the optical conversion layer 240. For example, one of the first light emitting element 201 and the second light emitting element 202 is the red light emitting element and the other is the green light emitting element. For example, the optical conversion layer 240 of the red light emitting element converts blue light into red light, and the optical conversion layer 240 of the green light emitting element converts blue light into green light.

For example, as shown in Fig. 2, the third light emitting element 203 is the blue light emitting element, and the third light emitting element 203 includes a light transmissive functional layer 250 configured to transmit first color light emitted by the light emitting functional layer 230, for example, blue light. For example, the light transmissive functional layer 250 may include scattering particles or refractive particles to increase a light extracting rate.

For example, as shown in Fig. 2, the light transmissive functional layer 250 has a part located in the opening 310, a surface, of the part, close to the base substrate 100 is closer to the base substrate 100 than the surface of the at least one part of the defining portion 320 away from the base substrate 100. For example, an orthographic projection of the light transmissive functional layer 250 in a plane perpendicular to the base substrate 100 overlaps an orthographic projection of the at least one part of the defining portion 320 in the plane. For example, a plane parallel to the base substrate 100 runs through the at least one part of the defining portion 320 and the light transmissive functional layer 250.

In some examples, the optical conversion layer 240 includes quantum dots. This embodiment of the present disclosure is not limited thereto. The optical conversion layer may further include a fluorescent material. For example, after incident light of a first color is incident onto the optical conversion layer 240, a material of the optical conversion layer 240 is excited by the incident light of the first color to emit light of another color, for example, second color light.

In some examples, as shown in Fig. 2, the optical conversion layer 240 has a part located in the opening 310, a surface, of the part, away from the base substrate 100 is closer to the base substrate 100 than the surface of the at least one part of the defining portion 320 away from the base substrate 100. For example, the optical conversion layer 240 may be completely located in at least the opening 310 defined by the defining portion 320.

For example, as shown in Fig. 2, the light transmissive functional layer 250 has the part located in the opening 310, a surface, of the part, away from the base substrate 100 is closer to the base substrate 100 than the surface of the at least one part of the defining portion 320 away from the base substrate 100. For example, the light transmissive functional layer 250 may be completely located in at least the opening 310 defined by the defining portion 320.

For example, as shown in Fig. 2, a surface of the optical conversion layer 240 close to the base substrate 100 may be a flat surface. For example, a surface of the light transmissive functional layer 250 close to the base substrate 100 may be a flat surface. For example, surfaces on sides that are of the optical conversion layers 240 in the light emitting elements that emit light of different colors and that are close to the base substrate 100 may be located on a same surface. For example, the surface of the optical conversion layer 240 close to the base substrate 100 may be located on the same surface as the surface of the light transmissive functional layer 250 close to the base substrate 100.

In some examples, as shown in Fig. 2, the surface, away from the base substrate, of the part of the optical conversion layer 240 located in the opening 310 includes a central part and an edge part, the central part is closer to the base substrate 100 than the edge part. For example, the surface on a side, that is of the part that is in the optical conversion layer 240 and that is located in the opening 310, away from the base substrate is a concave surface, and a highest point at an edge position in the concave surface is closer to the base substrate 100 than the surface of the defining portion 320 away from the base substrate 100.

For example, as shown in Fig. 2, the surface, away from the base substrate, of the part of the light transmissive functional layer 250 located in the opening 310 includes a central part and an edge part, the central part is closer to the base substrate 100 than the edge part.. For example, the surface on the side, that is of the part that is in the light transmissive functional layer 250 and that is located in the opening 310, away from the base substrate 100 may be a surface concave to the base substrate 100.

Certainly, this embodiment of the present disclosure is not limited thereto. The surface, of the part of the optical conversion layer located in the opening, away from the base substrate may be farther away from the base substrate than the surface of the defining portion away from the base substrate, or some positions of the surface, of the part of the optical conversion layer located in the opening, away from the base substrate may be flush with the surface of the defining portion away from the base substrate.

For example, as shown in Fig. 2, the optical conversion layer 240 in each light emitting element 200 is located in the opening corresponding to the light emitting element 200. For example, optical conversion layers 240 of adjacent light emitting elements 200 that emit light of different colors are spaced apart from each other. For example, a distance between the optical conversion layers 240 of the adjacent light emitting elements 200 that emit light of different colors is greater than a width of the defining portion 320. For example, the light transmissive functional layer 250 and the optical conversion layer 240 are spaced apart from each other.

For example, as shown in Fig. 2, in the direction perpendicular to the base substrate 100, minimum thicknesses of the optical conversion layers 240 of the light emitting elements 200 that emit light of different colors may be the same or may be different. For example, in the direction perpendicular to the base substrate 100, the minimum thickness of the optical conversion layer 240 may be the same as or different from the minimum thickness of the light transmissive functional layer 250.

In some examples, as shown in FIG, 2, the display substrate further includes a first insulation layer 400 located between the optical conversion layer 240 and the second electrode 220. The first insulation layer 400 has a part located in the opening 310, A surface, of the part, away from the base substrate 100 is closer to the base substrate 100 than the surface of the at least one part of the defining portion 320 away from the base substrate 100.

For example, the first insulation layer 400 may be an encapsulation layer, to encapsulate the light emitting functional layer and the second electrode of the light emitting element. For example, a distance d1 between a surface of the encapsulation layer away from the base substrate 100 and the base substrate 100 is different from a distance d2 between the surface of the at least one part of the defining portion 320 away from the base substrate 100 and the base substrate 100 by at least five microns. For example, a difference between the distance d1 and the distance d2 may be 5.5 microns. For example, a difference between the distance d1 and the distance d2 may be 6 microns. For example, a difference between the distance d1 and the distance d2 may be 6.5 microns. For example, a difference between the distance d1 and the distance d2 may be 7 microns. For example, a difference between the distance d1 and the distance d2 may be 7.5 microns. For example, a difference between the distance d1 and the distance d2 may be 8 microns. For example, a difference between the distance d1 and the distance d2 may be 8.5 microns. For example, a difference between the distance d1 and the distance d2 may be 9 microns. For example, a difference between the distance d1 and the distance d2 may be 9.5 microns. For example, a difference between the distance d1 and the distance d2 may be 10 microns.

For example, as shown in Fig. 2, the first insulation layer 400 covers the defining portion 320 and the opening 310, and the optical conversion layer 240 is located on the first insulation layer 400 in the opening 310. For example, the surface, of the part of the first insulation layer 400 located in the opening 310, away from the base substrate 100 is a flat surface.

For example, as shown in Fig. 2, only the second electrode 220 and the first insulation layer 400 are disposed between the optical conversion layer 240 and the light emitting functional layer 230, so as to greatly reduce the distance between the optical conversion layer and the light emitting functional layer.

For example, a distance between the optical conversion layer 240 and the light emitting functional layer 230 is less than 5 microns. For example, the distance between the optical conversion layer 240 and the light emitting functional layer 230 is less than 4.8 microns. For example, the distance between the optical conversion layer 240 and the light emitting functional layer 230 is less than 4.5 microns. For example, the distance between the optical conversion layer 240 and the light emitting functional layer 230 is less than 4.2 microns. For example, the distance between the optical conversion layer 240 and the light emitting functional layer 230 is less than 4 microns. For example, the distance between the optical conversion layer 240 and the light emitting functional layer 230 is less than 3.7 microns. For example, the distance between the optical conversion layer 240 and the light emitting functional layer 230 is less than 3.5 microns. For example, the distance between the optical conversion layer 240 and the light emitting functional layer 230 is less than 3.3 microns. For example, the distance between the optical conversion layer 240 and the light emitting functional layer 230 is less than 3 microns.

In some examples, as shown in Fig. 2, a thickness of the first insulation layer 400 is less than a thickness of the at least one part of the defining portion 320. For example, a difference between thicknesses of the first insulation layer 400 and the defining portion 320 is at least 1 micron. For example, the difference between thicknesses of the first insulation layer 400 and the defining portion 320 is at least 1.5 microns. For example, the difference between thicknesses of the first insulation layer 400 and the defining portion 320 is at least 2 microns. For example, the difference between thicknesses of the first insulation layer 400 and the defining portion 320 is at least 2.5 micron. For example, the difference between thicknesses of the first insulation layer 400 and the defining portion 320 is at least 3 microns. For example, the difference between thicknesses of the first insulation layer 400 and the defining portion 320 is at least 4 microns. For example, the difference between thicknesses of the first insulation layer 400 and the defining portion 320 is at least 5 micron.

For example, as shown in Fig. 2, a total thickness of the light emitting functional layer 230, the second electrode 220, and the first insulation layer 400 is less than the thickness of the defining portion 320, so that the optical conversion layer 240 may be formed within the opening 310 defined by the defining portion 320.

In some examples, as shown in Fig. 2, the first insulation layer 400 includes at least two film layers, such as a film layer 410 and a film layer 420, and a difference between thicknesses of different film layers is less than 1 micron. For example, the difference between thicknesses of different film layers is less than 0.9 microns. For example, the difference between thicknesses of different film layers is less than 0.8 microns. For example, the difference between thicknesses of different film layers is less than 0.7 microns. For example, the difference between thicknesses of different film layers is less than 0.6 microns. For example, the difference between thicknesses of different film layers is less than 0.5 microns. For example, the difference between thicknesses of different film layers is less than 0.4 microns.

For example, the first insulation layer 400 may include at least two inorganic insulation layers. For example, film layers included in the first insulation layer 400 may all be inorganic layers. For example, the film layers included in the first insulation layer 400 may all include silicon (Si).

When the first insulation layer is used as the encapsulation layer, by disposing only an inorganic insulation layer with a relatively small thickness, a depth of the opening can be maintained to the greatest extent, to form, such as print the optical conversion layer in the opening. Certainly, this embodiment of the present disclosure is not limited thereto. The first insulation layer may further include an organic insulation layer.

For example, a defining portion cross section that is of the defining portion 320 and that is cut by a plane (for example, an XZ plane) perpendicular to the base substrate 100 may be a trapezium, and an angle between an oblique side and a lower bottom of the trapezium is relatively small, for example, not greater than 45 degrees. This facilitates increasing a ratio of the maximum opening defining the light emitting functional layer to the maximum opening defining the optical conversion layer.

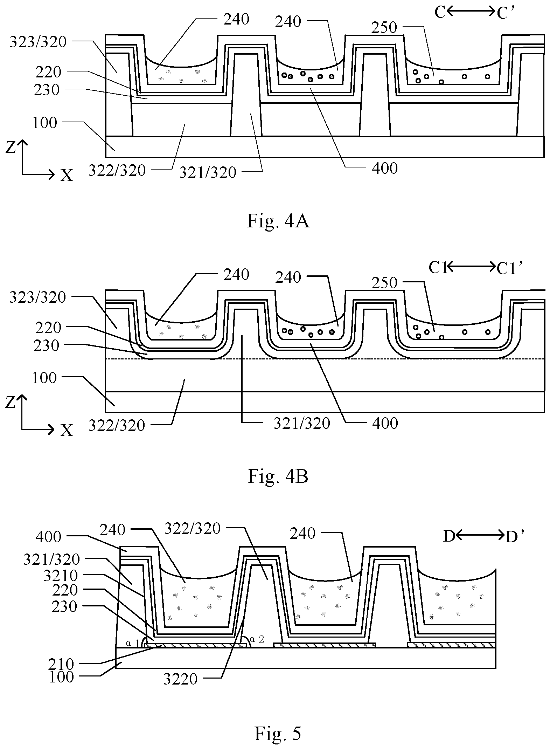

Fig. 3 is a schematic diagram of a partial cross-sectional structure cut along line BB' shown in Fig. 1A according to an example of an embodiment of the present disclosure. Fig. 4A is a schematic diagram of a partial cross-sectional structure cut along line CC' shown in Fig. 1A.

In some examples, as shown in Fig. 1A to Fig. 4A, the plurality of light emitting elements 200 includes light emitting elements 200 emitting light of at least two colors, for example, the first light emitting element 201, the second light emitting element 202, and the third light emitting element 203. The defining portion 320 located between the openings 310 corresponding to adjacent light emitting elements 200 of different colors includes the first sub-defining portion 321, and the defining portion 320 located between the openings 310 corresponding to adjacent light emitting elements 200 of a same color includes the second sub-defining portion 322. The maximum thickness of the first sub-defining portion 321 is greater than the maximum thickness of the second sub-defining portion 322, and a part that is in the second electrode 220 and that covers the second sub-defining portion 322 is continuously disposed.

The part as mentioned above in the second electrode 220 covering the second sub-defining portion 322 continuously disposed means that the second electrode 220 that covers a surface of the second sub-defining portion 322 away from the base substrate 100 and the second electrode 220 that covers a side surface of the second sub-defining portion 322 are a continuous structure. For example, a part that is in the second electrode 220 and that covers at least two light emitting elements is a continuous structure.

For example, a difference between the maximum thickness of the first sub-defining portion 321 and the maximum thickness of the second sub-defining portion 322 is at least 1 micron. For example, the difference between the maximum thickness of the first sub-defining portion 321 and the maximum thickness of the second sub-defining portion 322 is at least 2 microns. For example, the difference between the maximum thickness of the first sub-defining portion 321 and the maximum thickness of the second sub-defining portion 322 is at least 3 microns. For example, the difference between the maximum thickness of the first sub-defining portion 321 and the maximum thickness of the second sub-defining portion 322 is at least 4 microns. For example, the difference between the maximum thickness of the first sub-defining portion 321 and the maximum thickness of the second sub-defining portion 322 is at least 5 microns. For example, the difference between the maximum thickness of the first sub-defining portion 321 and the maximum thickness of the second sub-defining portion 322 is at least 6 microns. For example, the difference between the maximum thickness of the first sub-defining portion 321 and the maximum thickness of the second sub-defining portion 322 is at least 7 microns.

For example, as shown in Fig. 1A to Fig. 4A, the defining portion 320 includes a circle of annular defining portion 323 that surrounds the plurality of light emitting elements 200. The maximum thickness of the annular defining portion 323 is greater than the maximum thickness of the second sub-defining portion 322, to define the optical conversion layer 240 within the opening 310 of the pixel defining pattern 300, thereby preventing the optical conversion layer 240 from overflowing from the defining portion 320. For example, the maximum thickness of the annular defining portion 323 is the same as the maximum thickness of the first sub-defining portion 321. However, this embodiment is not limited thereto. The maximum thickness of the annular defining portion may be greater than the maximum thickness of the first sub-defining portion, or may be less than the maximum thickness of the first sub-defining portion.

For example, as shown in Fig. 2 and Fig. 4A, a slope angle of a slope included in the surface of the first sub-defining portion 321 away from the base substrate 100 is equal to a slope angle of a slope included in the surface of the second sub-defining portion 322 away from the base substrate 100. Certainly, this embodiment of the present disclosure is not limited thereto. The slope angle of the slope included in the surface of the first sub-defining portion away from the base substrate may be greater than the slope angle of the slope included in the surface of the second sub-defining portion away from the base substrate, so as to increase continuity of the second electrode at a position at which the second sub-defining portion is covered.

For example, as shown in Fig. 3, the optical conversion layer 240 covers the surface side of the second sub-defining portion 322 away from the base substrate 100, for example, the optical conversion layer 240 at the second sub-defining portion is a continuous structure. For example, the optical conversion layer 240 includes a part located between openings defined by adjacent second sub-defining portions 322 and a part that covers the second sub-defining portion 322.

For example, as shown in Fig. 3, the surface of the optical conversion layer 240 away from the base substrate 100 is farther away from the base substrate 100 than the surface of the second sub-defining portion 322 away from the base substrate 100. For example, a surface, of a part in the optical conversion layer 240 located on the second sub-defining portion 322, away from the base substrate 100 is closer to the base substrate 100 than the surface of the first sub-defining portion 321 away from the base substrate 100.

For example, as shown in Fig. 4A, when the maximum thickness of the second sub-defining portion 322 is less than the maximum thickness of the first sub-defining portion 321, an opening formed between adjacent first sub-defining portions 321 is used to define a position of the optical conversion layer 240, to prevent the optical conversion layer 240 from overflowing from the defining portion 320. In this case, the optical conversion layer 240 may cover the second sub-defining portion 322. For example, optical conversion layers 240 of adjacent light emitting elements 200 of a same color may be a continuous structure, and the first sub-defining portion 321 is disposed between optical conversion layers 240 of adjacent light emitting elements 200 of different colors, so that the two are spaced apart from each other.

Fig. 2 schematically shows that the second electrode 220 that covers a plurality of first sub-defining portions 321 is a continuously disposed film layer. However, in an actual product, when a thickness of the first sub-defining portion 321 is set to be relatively large to form the opening 310 that accommodates the optical conversion layer 240, the second electrode 220 is easily disconnected at an edge of the first sub-defining portion 321. As a result, the second electrode 220 that covers the defining portion 320 between adjacent light emitting elements 220 of different colors is a non-continuous film layer, affecting the display effect. In the display substrate provided in an example of this embodiment of the present disclosure, the defining portion is set to include sub-defining portions with at least two different thicknesses, to ensure continuity of the second electrode at a position with the smaller thickness, thereby improving the display effect of the display substrate.

Fig. 1B is a schematic diagram of a partial planar structure of a display substrate according to an example of an embodiment of the present disclosure. Fig. 4B is a schematic diagram of a partial cross-sectional structure cut along line C1C1' shown in Fig. 1B. The display substrate shown in Fig. 1B differs from the display substrate shown in Fig. 1A in that shapes of the openings of the pixel defining patters are different and widths of the second sub-defining portions are different.

For example, as shown in Fig. 1B and Fig. 4B, the first sub-defining portion 321 may be a structure integrally formed with the second sub-defining portion 322, or the two may be separately formed structures. For example, the second sub-defining portion 322 includes only a part with a smaller thickness, and the first sub-defining portion 321 includes a part with the same thickness as the second sub-defining portion 322 (for example, the part below the dash line) and a part exceeding the second sub-defining portion 322 (for example, the part above the dash line). For example, a position at which the first sub-defining portion 321 is connected to the second sub-defining portion 322 may be an arc-shaped surface, so that the cross section that is of the concave part formed by the first sub-defining portion 321 and the second sub-defining portion 322 and that is cut by the XZ plane may be U-shaped or V-shaped.

Fig. 5 is a schematic diagram of a partial cross-sectional structure cut along line DD' shown in Fig. 1A according to another example of an embodiment of the present disclosure. The display substrate shown in Fig. 5 differs from the display substrate shown in Fig. 3 in that, a surface of the first sub-defining portion 321 away from the base substrate 100 includes a first slope 3210, and a surface of the second sub-defining portion 322 away from the base substrate 100 includes a second slope 3220, where a slope angle α1 of the first slope 3210 is greater than a slope angle α2 of the second slope 3220. Structures such as the base substrate, the first insulation layer, the light emitting functional layer, and the first electrode in the display substrate shown in Fig. 5 may have the same features as structures such as the base substrate, the first insulation layer, the light emitting functional layer, and the first electrode in the display substrate shown in Fig. 3. Details are not described herein again.

The slope angle of the first slope formed by the surface of the first sub-defining portion away from the base substrate is an angle between a surface of a part that is of the first sub-defining portion and that is close to the base substrate and a plane parallel to the base substrate. The slope angle of the second slope formed by the surface of the second sub-defining portion away from the base substrate is an angle between a surface of a part that is of the second sub-defining portion and that is close to the base substrate and the plane parallel to the base substrate. The slope angle of the first sub-defining portion may be an angle between a straight line and a contact position of the first electrode when a shape that is of the first slope and that is cut by the XZ plane is the straight line, or an angle between a tangent, at an intersection between a curved line and the first electrode, and the X direction when a shape that is of the first slope and that is cut by the XZ plane is the curved line, and the slope angle of the second sub-defining portion may be an angle between a straight line and the contact position of the first electrode when a shape that is of the second slope and that is cut by the YZ plane is the straight line, or an angle between a tangent, at an intersection between a curved line and the first electrode, and the X direction when a shape that is of the first slope and that is cut by the XZ plane is the curved line. However, this embodiment is not limited thereto. For example, the slope angle may be an angle between a tangent at a middle point of a curved line that is of the slope and that is cut by the XZ plane (or the YZ plane) and the X direction (or the Y direction).

In the display substrate in the example shown in Fig. 5, the slope angle of the second sub-defining portion is set to be less than the slope angle of the first sub-defining portion, to implement continuity of covering the second sub-defining portion, thereby improving the display effect of the display substrate.

For example, as shown in Fig. 5, the maximum thickness of the second sub-defining portion 322 is relatively large, so that the optical conversion layers 240 of adjacent light emitting elements 200 of a same color are spaced apart from each other. For example, the surface of the second sub-defining portion 322 away from the base substrate 100 is farther away from the base substrate 100 than the surface of the optical conversion layer 240 close to the base substrate 100. For example, the surface of the second sub-defining portion 322 away from the base substrate 100 may be farther, than the surface of the optical conversion layer 240 away from the base substrate 100, away from the base substrate 100, or may be flush with the surface of the optical conversion layer 240 away from the base substrate 100, or may be closer to the base substrate 100 than the surface of the optical conversion layer 240 away from the base substrate 100. This is not limited in this embodiment of the present disclosure, and may be set based on continuity of the second electrode.

In some examples, as shown in Fig. 1A to Fig. 5, at least two adjacent light emitting elements 200 arranged in a first direction emit light of a same color, and at least two adjacent light emitting elements 200 arranged in a second direction emit light of different colors, and the first direction intersects with the second direction. Fig. 1A to Fig. 5 schematically show that the first direction is a Y direction, and the second direction is an X direction. However, this embodiment is not limited thereto, and the first direction may be interchanged with the second direction. For example, the first direction is perpendicular to the second direction, but this embodiment is not limited thereto. An angle between the first direction and the second direction may be 70 to 110 degrees, or 80 to 100 degrees, or 85 to 95 degrees. For example, one of the first direction and the second direction is a row direction, and the other is a column direction.

In some examples, as shown in Fig. 1A to Fig. 5, the defining portion 320 includes a plurality of first sub-defining portions 321 and a plurality of second sub-defining portions 322, at least one of the first sub-defining portions 321 extends in the first direction, and the second sub-defining portion 322 extending in the second direction is disposed between two adjacent first sub-defining portions 321. For example, second sub-defining portions 322 disposed between the two adjacent first sub-defining portions 321 are disposed parallel to each other. For example, Fig. 1A schematically shows that the shape of the opening 310 defined by the defining portion 320 may be a rectangle, but this embodiment is not limited thereto. The shape of the opening 310 may alternatively be a strip shape shown in Fig. 1B, or another shape, for example, an ellipse, a circle, a trapezium, or the like.

For example, the first sub-defining portion 321 and the second sub-defining portion 322 may be integrally disposed structures in a same step of process, or may be structures formed in different steps. For example, the annular defining portion 323, the first sub-defining portion 321, and the second sub-defining portion 322 may be integrally disposed structures in a same step of process, or may be structures formed in different steps.

In some examples, as shown in Fig. 1A and Fig. 3, the display substrate further includes a signal transmission line 500, located on a side of the first electrode 210 facing the base substrate 100. The display substrate includes a display region 101 and a peripheral region 102 that surrounds the display region 101. The signal transmission line 500 is located in the peripheral region 102. For example, the signal transmission line 500 may be a circle of wiring surrounding the display region 101.

In some examples, as shown in Fig. 1A and Fig. 3, the display substrate further includes a transmission portion 510, located on a side of the first electrode 210 facing the base substrate 100, and is electrically connected to the signal transmission line 500. The transmission portion 510 is located on a side of a part, on an utmost edge in the defining portion 320, close to the display region 101, and the second electrode 220 is electrically connected to the transmission portion 510. For example, the part on the utmost edge of the defining portion 320 may be the annular defining portion 323.

For example, as shown in Fig. 1A and Fig. 3, the signal transmission line 500 is configured to transmit a VSS signal, for example, a negative voltage signal to the second electrode 220.

For example, as shown in Fig. 1A and Fig. 3, a boundary of the second electrode 220 exceeds a boundary of the light emitting functional layer 230. A part that is of the second electrode 220 and that exceeds the boundary of the light emitting functional layer 230 is electrically connected to the transmission portion 510.

For example, as shown in Fig. 1A and Fig. 3, an opening 3100 is provided between the annular defining portion 323 and the second sub-defining portion 322 that is closest to the annular defining portion 323 and that is spaced apart from the annular defining portion 323. No light emitting element is provided in the opening 3100.

For example, as shown in Fig. 1A and Fig. 3, the second electrode 220 located in the opening 3100 is electrically connected to the transmission portion 510. For example, the transmission portion 510 is disposed directly opposite to the opening 3100.

For example, as shown in Fig. 1A and Fig. 3, a part of the light emitting functional layer 2300 may be disposed in the opening 3100, or no light emitting functional layer 230 may be disposed in the opening 3100. For example, in the opening 3100, at least one part of the second electrode 220 does not overlap the light emitting functional layer. For example, the part that is of the second electrode 220 in the opening 3100 and that does not overlap the light emitting functional layer 230 is electrically connected to the transmission portion 510.

For example, as shown in Fig. 1A and Fig. 3, an electrode connection portion 501 disposed at the same layer as the first electrode 210 may be disposed in the opening 3100, and the second electrode 220 may be electrically connected to the transmission portion 510 through the electrode connection portion 501. Certainly, this embodiment of the present disclosure is not limited thereto. The electrode connection portion disposed at the same layer as the first electrode 210 may alternatively not be disposed in the opening, and the second electrode is electrically connected to the transmission portion 510 through a via hole in the insulation layer.

In this embodiment of the present disclosure, the thickness of a part of the defining portion located in a central region of the pixel defining pattern is set to be less than the thickness of the defining portion on the edge of the pixel defining pattern, and the transmission portion of the signal transmission line electrically connected to the second electrode is disposed at a side of the at least one part of the defining portion located on the edge and that is close to the defining portion with a relatively small thickness, so that when the second electrode disposed in at least some regions in the display region is continuously disposed, the part of the continuously disposed second electrode is electrically connected to the transmission portion as mentioned above, to achieve a good electrical connection effect of the second electrode.

For example, the display substrate further includes a pixel circuit electrically connected to the light emitting element, to drive the light emitting element to emit light. The display substrate further includes a data line electrically connected to the pixel circuit. The data line is located between the first electrode of the light emitting element and the base substrate. The signal transmission line may be disposed at the same layer as the data line.

For example, the transmission portion 510 may be disposed at the same layer as the signal transmission line 500. For example, the transmission portion 510 may be a part of the signal transmission line 500.

For example, the transmission portion 510 may be located between a film layer at which the signal transmission line 500 is located and a film layer at which the first electrode 210 of the light emitting element 200 is located. For example, the transmission portion 510 may be disposed at the same layer as at least one part of the first electrode 210. For example, the transmission portion 510 may be located between a film layer at which the second electrode 220 of the light emitting element 200 is located and the film layer at which the first electrode 210 is located.

Fig. 2, Fig. 4A, and Fig. 5 do not show a film layer between the first electrode 210 and the base substrate 100. Fig. 3 only schematically shows the transmission portion 510 and an insulation layer that is located between the transmission portion 510 and the first electrode 210. However, another film layer between the first electrode 210 and the base substrate 100 is not shown.

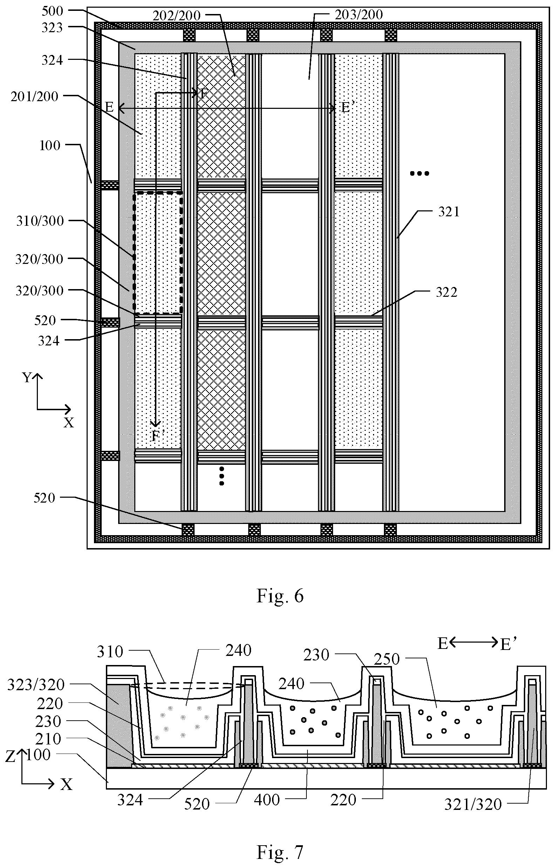

Fig. 6 is a schematic diagram of a partial planar structure of a display substrate according to another example of an embodiment of the present disclosure. Fig. 7 is a schematic diagram of a partial cross-sectional structure cut along line EE' shown in Fig. 6. The display substrate in the example shown in Fig. 6 differs from the display substrate shown in Fig. 1A in that structural features of the defining portions 320 are different. The base substrate 100, the light emitting element 200, and the first insulation layer 400 that are included in the display substrate in the example shown in Fig. 6 may have the same features as the base substrate 100, the light emitting element 200, and the first insulation layer 400 that are included in the display substrate in the example shown in Fig. 1A. Details are not described herein again.

In some examples, as shown in Fig. 6 and Fig. 7, the display substrate may further include an electrode overlapping portion 520. The electrode overlapping portion 520 is located on a side of the defining portion 320 facing the base substrate 100, and in the direction perpendicular to the base substrate 100, the defining portion 320 overlaps the electrode overlapping portion 520. The defining portion 320 includes a hole or a slot 324 exposing the electrode overlapping portion 520, and the second electrode 220 is electrically connected to the electrode overlapping portion 520 via the hole or the slot 324.

For example, the slot 324 or the hole includes a carbon element. For example, the slot 324 or the hole may further include an oxygen element, or the like.

For example, the area of actual contact between the second electrode 220 and the electrode overlapping portion 520 is less than a width of the slot 324, or less than a maximum size of the hole.

For example, the electrode overlapping portion 520 in the example shown in Fig. 6 may have the same function as the transmission portion 510 in the example shown in Fig. 1A. For example, the second electrode 220 is electrically connected to the signal transmission line 500, and the electrode overlapping portion 520 may have the same structural features as the transmission portion 510, or may have different structural features. This is not limited in this embodiment of the present disclosure. For example, the electrode overlapping portion may also be referred to as an auxiliary cathode.

In some examples, as shown in Fig. 6 and Fig. 7, at least one part of the electrode overlapping portion 520 and at least one part of the defining portion 320 extend in a same direction. For example, in the case where the electrode overlapping portion 520 overlaps the defining portion 320 extending in the first direction, the electrode overlapping portion 520 extends in the first direction. For example, in the case where the electrode overlapping portion 520 overlaps the defining portion 320 extending in the second direction, the electrode overlapping portion 520 extends in the second direction.

For example, at least one part of the electrode overlapping portion 520 overlaps at least one part of the defining portion 320. For example, the defining portion 320 covers an edge of the electrode overlapping portion 520.

For example, an orthographic projection of the electrode overlapping portion 520 on at least one side that surrounds one opening on the base substrate 100 is located within an orthographic projection of the defining portion 320 on the base substrate 100, to alleviate non-uniformity caused by voltage drops at various positions of the display substrate.

For example, as shown in Fig. 6 and Fig. 7, an extension direction of the slot 324 in the defining portion 320 is the same as an extension direction of the defining portion 320, and the extension direction of the slot 324 is the same as an extension direction of the electrode overlapping portion 520 exposed by the slot 324.

For example, as shown in Fig. 6, the defining portion 320 includes a plurality of first sub-defining portions 321 that extend in the first direction and that are arranged in the second direction and second sub-defining portions 322 that are located between adjacent first sub-defining portions 321 and that extend in the second direction, and the plurality of second sub-defining portions 322 disposed between the adjacent first sub-defining portions 321 are arranged in the first direction. For example, the second sub-defining portions 322 arranged in the second direction are located on a straight line.

For example, the slot 324 provided in one first sub-defining portion 321 may run through the first sub-defining portion 321 in the first direction, or may be located only at some positions in the first sub-defining portion 321, and does not run through the first sub-defining portion 321. For example, one slot 324 extending in the first direction or a plurality of slots 324 may be provided in one first sub-defining portion 321. The plurality of slots 324 may extend in the first direction and are arranged in the second direction, as shown in Fig. 6, or may extend in the first direction and are arranged at intervals in the first direction.

For example, the slot 324 provided in one second sub-defining portion 322 may run through the second sub-defining portion 322 in the second direction, or may be located only at some positions in the second sub-defining portion 322, and does not run through the second sub-defining portion 322. For example, one slot 324 extending in the second direction or a plurality of slots 324 may be provided in one second sub-defining portion 322. The plurality of slots 324 may extend in the second direction and are arranged in the first direction, as shown in Fig. 6, or may extend in the second direction and are arranged at intervals in the second direction. For example, one first sub-defining portion 321 is disposed between two adjacent second sub-defining portions 322 arranged in the second direction. The slot 324 provided in the second sub-defining portion 322 may run through the first sub-defining portion 321, or may be located only in the second sub-defining portion 322, for example, does not run through the second sub-defining portion 322, or for example, a spacing is provided between the slot 324 and the first sub-defining portion 321.

For example, Fig. 6 schematically shows that each first sub-defining portion 321 and each second sub-defining portion 322 are provided with slots 324, and two slots 324 are provided in each sub-defining portion. No slot is provided in the annular defining portion 323. However, this embodiment of the present disclosure is not limited thereto. For example, in an example of this embodiment of the present disclosure, only the first sub-defining portion is provided with a slot, and the second sub-defining portion and the annular defining portion are not provided with slots. For example, in an example of this embodiment of the present disclosure, only the second sub-defining portion is provided with a slot, and the first sub-defining portion and the annular defining portion are not provided with slots. For example, in an example of this embodiment of the present disclosure, the first sub-defining portion and the second sub-defining portion of a certain region are provided with slots, and the first sub-defining portion in another region is not provided with a slot. For example, in an example in this embodiment of the present disclosure, the first sub-defining portion in a certain region is provided with a slot, and the second sub-defining portion in another region is provided with a slot. For example, slots formed in the first sub-defining portion and the second sub-defining portion may form a connected meshed shape.

For example, quantities of slots provided in different first sub-defining portions may be the same or may be different. For example, quantities of slots provided in different second sub-defining portions may be the same or may be different. For example, a quantity of slots provided in one first sub-defining portion may be the same as or may be different from a quantity of slots provided in one second sub-defining portion.

For example, as shown in Fig. 7, only the second electrode 220 is disposed in the slot 324. For example, the defining portion 230 formed through patterning is provided with the slot 324. After the light emitting functional layer 230 is formed, the light emitting functional layer is filled in the slot 324. Before the second electrode 220 is formed, at least one part of the light emitting functional layer 230 in the slot 324 is removed by using laser, so that the slot 324 exposes the electrode overlapping portion 520, and a part of the second electrode 220 is formed in the slot 324 to be connected to the electrode overlapping portion 520.

In some examples, as shown in Fig. 6 and Fig. 7, the display substrate further includes the signal transmission line 500, located on the side of the first electrode 210 facing the base substrate 100. The display substrate includes the display region and the peripheral region that surrounds the display region (with reference to the display region 101 and the peripheral region 102 shown in Fig. 1A), the signal transmission line 500 is located in the peripheral region, and the second electrode 220 is electrically connected to the signal transmission line 500 by using the electrode overlapping portion 520.

For example, as shown in Fig. 6 and Fig. 7, the electrode overlapping portion 520 extends to the peripheral region to be electrically connected to the signal transmission line 500. For example, the electrode overlapping portion 520 may be formed into a meshed shape.

For example, as shown in Fig. 6 and Fig. 7, using the first sub-defining portion 321 as an example, each first sub-defining portion 321 is provided with two slots 324, and the two slots 324 divide each first sub-defining portion 321 into three parts. In the first sub-defining portion 321, the maximum thickness of a part located in the middle is greater than the maximum thicknesses of two parts located on two sides. For example, in the first sub-defining portion 321, a surface of the part located in the middle away from the base substrate 100 is farther, than the surface of the optical conversion layer 240 away from the base substrate 100, away from the base substrate 100, and a surface of at least one part in the two parts located on two sides away from the base substrate 100 is closer to the base substrate 100 than the surface of the optical conversion layer 240 away from the base substrate 100.

For example, as shown in Fig. 6 and Fig. 7, the optical conversion layer 240 covers at least one part of the two parts located on two sides in the first sub-defining portion 321. For example, maximum thicknesses of the two parts that are in the first sub-defining portion 321 and that are located on two sides may be the same or may be different. For example, the second sub-defining portion 322 may be provided with three parts that have the same features as the first sub-defining portion 321. Certainly, this embodiment of the present disclosure is not limited to that each sub-defining portion is provided with three part shown in Fig. 7. When there is one slot, each sub-defining portion may include two parts, and maximum thicknesses of the two parts may be the same or may be different. When there is one slot, each sub-defining portion may include two parts, and at least one of the two parts may be set to a step structure. The maximum thickness of a part located in the middle in the step structure is larger. When there are three slots, each sub-defining portion may include four parts, where the maximum thickness of at least one part located in the middle is greater than the maximum thickness of at least one part located on an edge.

In the display substrate provided in this embodiment of the present disclosure, a slot is provided in the defining portion of the pixel defining pattern, so that the second electrode of the light emitting element is electrically connected to the electrode overlapping portion through the slot. This facilitates improving the effect of an electrical connection between the second electrode and the electrode overlapping portion. In addition, at least one sub-defining portion in the defining portion is set to include three parts, and the maximum thickness of the middle part is greater than the maximum thicknesses of two parts on two sides. In this way, the optical conversion layer is filled in the opening defined by the defining portion, and the second electrode has good continuity.

In some examples, as shown in Fig. 7, the electrode overlapping portion 520 includes at least one film layer disposed at the same layer as the first electrode 210. For example, the first electrode 210 may include a plurality of film layers, the electrode overlapping portion 520 may be one film layer, and the electrode overlapping portion 520 and one film layer in the first electrode 210 may be formed in a same step of patterning process.

For example, as shown in Fig. 7, the electrode overlapping portion 520 is spaced apart from the first electrode 210 and is insulated from the first electrode 210.

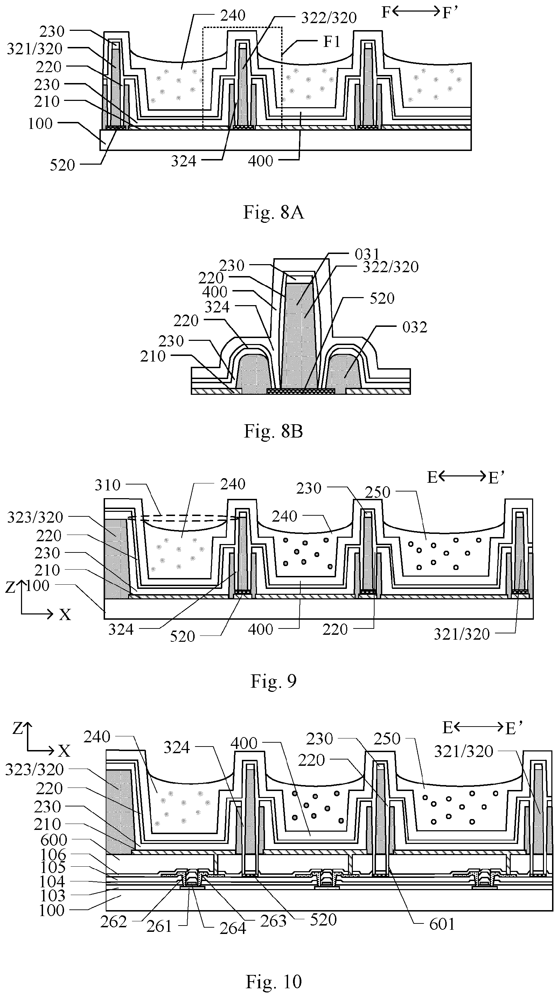

Fig. 8A is a schematic diagram of a partial cross-sectional structure cut along line FF' shown in Fig. 6. Fig. 8B is a partial enlarged schematic diagram of an F1 region shown in Fig. 8A.

In some examples, as shown in Fig. 6 to Fig. 8A, a ratio of a maximum thickness of the defining portion 320 between light emitting elements 200 that emit light of different colors to a maximum thickness of the defining portion 320 between light emitting elements 200 that emit light of a same color is 0.8 to 1. For example, the ratio of the maximum thickness of the defining portion 320 between light emitting elements 200 that emit light of different colors to the maximum thickness of the defining portion 320 between light emitting elements 200 that emit light of a same color is 0.85 to 0.88. For example, the ratio of the maximum thickness of the defining portion 320 between light emitting elements 200 that emit light of different colors to the maximum thickness of the defining portion 320 between light emitting elements 200 that emit light of a same color is 0.9 to 0.95. For example, the ratio of the maximum thickness of the defining portion 320 between light emitting elements 200 that emit light of different colors to the maximum thickness of the defining portion 320 between light emitting elements 200 that emit light of a same color is 0.92 to 0.97. For example, the maximum thickness of the defining portion 320 between light emitting elements 200 that emit light of different colors is the same as the maximum thickness of the defining portion 320 between light emitting elements 200 that emit light of a same color.

For example, as shown in Fig. 6 to Fig. 8A, the defining portion 320 between light emitting elements 200 that emit light of different colors is the first sub-defining portion 321, and the defining portion 320 between light emitting elements 200 that emit light of a same color is the second sub-defining portion 322. A ratio of the maximum thickness of the first sub-defining portion 321 to the maximum thickness of the second sub-defining portion 322 is 0.8 to 1. For example, the ratio of the maximum thickness of the first sub-defining portion 321 to the maximum thickness of the second sub-defining portion 322 is 0.9 to 0.95. For example, the ratio of the maximum thickness of the first sub-defining portion 321 to the maximum thickness of the second sub-defining portion 322 is 0.92 to 0.97. For example, the maximum thickness of the first sub-defining portion 321 is the same as the maximum thickness of the second sub-defining portion 322.

In the display substrate provided in this embodiment of the present disclosure, when the maximum thickness of the defining portion that extends in the first direction is basically the same as the maximum thickness of the defining portion that extends in the second direction, the slot exposing the electrode overlapping portion is provided in the defining portion, so that the second electrode is electrically connected to the electrode overlapping portion through the slot, thereby implementing the effect of a good electrical connection between the second electrode and the signal transmission line.

For example, as shown in Fig. 8B, the second electrode 220 located on a middle defining portion 031 and the second electrode 220 located on defining portions 032 on either side are disconnected structures. The slot 324 is provided between the middle defining portion 031 and the defining portions 032 on either side, and the light emitting functional layer 230 in the slot 324 is removed before the second electrode 220 is formed, so that the second electrode 220 can be formed in the slot 324, to be electrically connected to the electrode overlapping portion 520.

For example, the same as the example shown in Fig. 8B, in the defining portions shown in Fig. 7, and Fig. 9 to Fig. 15, the second electrode 220 located on the middle defining portion and the second electrode 220 located on the defining portions on either side are disconnected structures. The slot 324 is provided between the middle defining portion and the defining portions on either side, and the light emitting functional layer 230 in the slot 324 is removed before the second electrode 220 is formed, so that the second electrode 220 can be formed in the slot 324, to be electrically connected to the electrode overlapping portion 520.

Fig. 9 is a schematic diagram of a partial cross-sectional structure cut along line EE' shown in Fig. 6 according to another example of an embodiment of the present disclosure. The display substrate in the example shown in Fig. 9 differs from the display substrate in the example shown in Fig. 7 in that structures of the electrode overlapping portions 520 are different. Structures such as the base substrate, the light emitting element, the pixel defining pattern, and the first insulation layer in the display substrate in the example shown in Fig. 9 may have the same features as structures such as the base substrate, the light emitting element, the pixel defining pattern, and the first insulation layer in the display substrate in the example shown in Fig. 7. Details are not described herein again.

In some examples, as shown in Fig. 9, the electrode overlapping portion 520 includes a plurality of film layers, and a distance between a surface of the electrode overlapping portion 520 away from the base substrate 100 and the base substrate 100 is greater than a distance between a surface of the first electrode 210 away from the base substrate 100 and the base substrate 100. For example, a thickness of the electrode overlapping portion 520 is greater than a thickness of the first electrode 210.

In the display substrate provided in this embodiment of the present disclosure, the thickness of the electrode overlapping portion is set to be greater than the thickness of the first electrode, to facilitate an electrical connection between the second electrode and the electrode overlapping portion through the slot, thereby reducing resistance of the second electrode.

In some examples, as shown in Fig. 9, the electrode overlapping portion 520 includes a film layer located on a side of the first electrode 210 away from the base substrate 100. For example, the electrode overlapping portion 520 includes a film layer disposed at the same layer as the first electrode 210 and a film layer located on a side of the first electrode 210 away from the base substrate 100. For example, the film layer in the electrode overlapping portion 520 disposed in the same layer as the first electrode 210 and the first electrode 210 may be formed in a same step of the patterning process.

Fig. 10 is a schematic diagram of a partial cross-sectional structure cut along line EE' shown in Fig. 6 according to another example of an embodiment of the present disclosure. The display substrate in the example shown in Fig. 10 differs from the display substrate in the example shown in Fig. 7 in that positions of the electrode overlapping portions 520 are different. Structures such as the base substrate, the light emitting element, and the pixel defining pattern in the display substrate in the example shown in Fig. 10 may have the same features as structures such as the base substrate, the light emitting element, and the pixel defining pattern shown in Fig. 7. Details are not described herein again.

For example, as shown in Fig. 10, the electrode overlapping portion 520 is located between the first electrode 210 and the base substrate 100.

For example, as shown in Fig. 10, the display substrate further includes a pixel circuit electrically connected to the first electrode 210 of the light emitting element 200, the pixel circuit includes a light emitting control transistor. For example, the light emitting control transistor includes an active layer 261, a gate 264, a source 262, and a drain 263. The drain 263 is electrically connected to the first electrode 210 of the light emitting element 200. For example, the electrode overlapping portion 520 is disposed at the same layer as the source 262.

For example, as shown in Fig. 10, the display substrate further includes a first gate insulation layer 103, a second gate insulation layer 104, an interlayer insulation layer 105, a passivation layer 106, and a planarization layer 600. For example, the planarization layer 600 has a via hole or a slot 601 corresponding to the slot 324.

In some examples, as shown in Fig. 10, the planarization layer 600 is located between the first electrode 210 of the light emitting element 200 and the base substrate 100.

For example, the electrode overlapping portion 520 may include a plurality of film layers, and the plurality of film layers may include a film layer disposed at the same layer as the first electrode 210, and a film layer disposed at the same layer as the source of the light emitting control transistor.

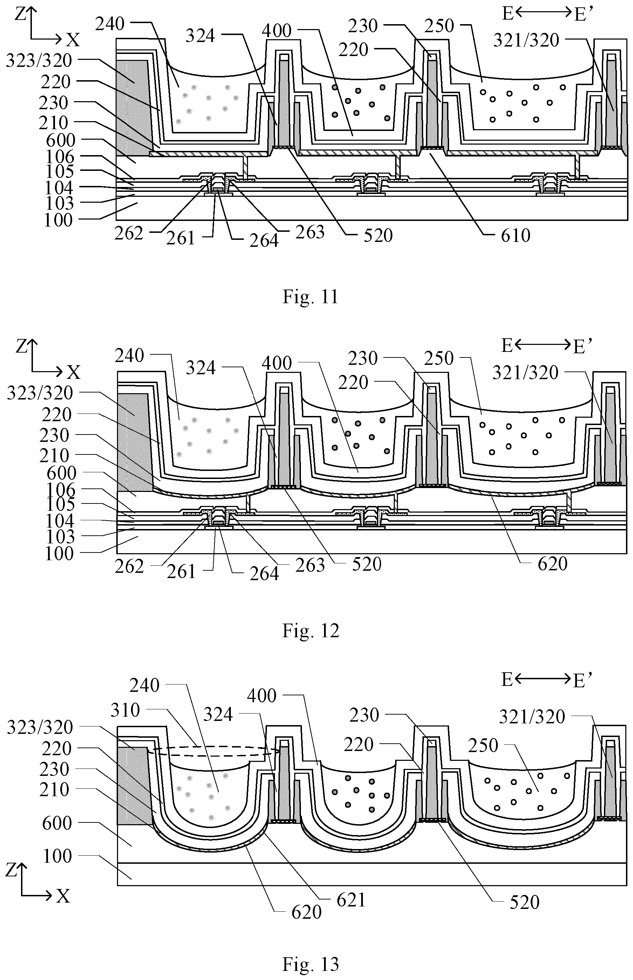

Fig. 11 is a schematic diagram of a partial cross-sectional structure cut along line EE' shown in Fig. 6 according to another example of an embodiment of the present disclosure. The display substrate in the example shown in Fig. 11 differs from the display substrate in the example shown in Fig. 10 in that positions of the electrode overlapping portions 520 are different, and structures of the planarization layers 600 are different. Structures such as the base substrate, the light emitting element, and the pixel defining pattern in the display substrate in the example shown in Fig. 11 may have the same features as structures such as the base substrate, the light emitting element, and the pixel defining pattern shown in Fig. 10. Details are not described herein again.

In some examples, as shown in Fig. 11, the planarization layer 600 includes a planarization layer convex portion 610, and an orthographic projection of the planarization layer convex portion 610 on the base substrate 100 overlaps an orthographic projection of the electrode overlapping portion 520 on the base substrate 100, so that the distance between the surface of the electrode overlapping portion 520 away from the base substrate 100 and the base substrate 100 is greater than the distance between the surface of the first electrode 210 away from the base substrate 100 and the base substrate 100. By disposing the planarization layer convex portion in the planarization layer, the position of the electrode overlapping portion can be raised, to facilitate electrically connection between the second electrode of the light emitting element and the electrode overlapping portion.

For example, as shown in Fig. 11, in the direction perpendicular to the base substrate 100, the planarization layer convex portion 610 does not overlap the light emitting region of the light emitting element 200.

Fig. 12 is a schematic diagram of a partial cross-sectional structure cut along line EE' shown in Fig. 6 according to another example of an embodiment of the present disclosure. The display substrate in the example shown in Fig. 12 differs from the display substrate in the example shown in Fig. 11 in that structures of the planarization layers 600 are different. The position of the electrode overlapping portion in the display substrate shown in Fig. 12 may be the same as the position of the electrode overlapping portion in the display substrate shown in Fig. 11, or may be the same as the position of the electrode overlapping portion in the display substrate in any one of the examples shown in Fig. 7 to Fig. 10. This is not limited in this example. Structures such as the base substrate, the light emitting element, and the pixel defining pattern in the display substrate in the example shown in Fig. 12 may have the same features as structures such as the base substrate, the light emitting element, and the pixel defining pattern shown in Fig. 10. Details are not described herein again.

In some examples, as shown in Fig. 12, the planarization layer 600 includes a groove 620, and in the direction perpendicular to the base substrate 100, the defining portion 320 does not overlap the groove 620. The first electrode 210 and the light emitting functional layer 230 of at least some of the light emitting elements 200 are located in the groove 620, and a surface of the light emitting functional layer 230 close to the base substrate 100 is closer to the base substrate 100 than the surface of the electrode overlapping portion 520 away from the base substrate 100.

For example, a thickness at a position at which the planarization layer is provided with a groove to a thickness at a position at which the planarization layer without groove is provided may be 0.1 to 0.9. For example, the thickness at the position at which the planarization layer is provided with a groove to the thickness at the position at which the planarization layer without groove is provided may be 0.15 to 0.7. For example, the thickness at the position at which the planarization layer is provided with a groove to the thickness at the position at which the planarization layer without groove is provided may be 0.2 to 0.85. For example, the thickness at the position at which the planarization layer is provided with a groove to the thickness at the position at which the planarization layer without groove is provided may be 0.25 to 0.75. For example, the thickness at the position at which the planarization layer is provided with a groove to the thickness at the position at which the planarization layer without groove is provided may be 0.3 to 0.85. For example, the thickness at the position at which the planarization layer is provided with a groove to the thickness at the position at which the planarization layer without groove is provided may be 0.4 to 0.5. For example, the thickness at the position at which the planarization layer is provided with a groove to the thickness at the position at which the planarization layer without groove is provided may be 0.35 to 0.65. For example, the thickness at the position at which the planarization layer is provided with a groove to the thickness at the position at which the planarization layer without groove is provided may be 0.55 to 0.6.

In the display substrate provided in this embodiment of the present disclosure, the groove is provided in the planarization layer, and the electrode overlapping portion is disposed at a spacing between adjacent grooves. This is equivalent to disposing the electrode overlapping portion at a relatively high position, which facilitates the electrically connection between the second electrode of the light emitting element and the electrode overlapping portion.

For example, as shown in Fig. 12, the surface of the light emitting functional layer 230 away from the base substrate 100 may be farther away from the base substrate 100 than the surface of the electrode overlapping portion 520 away from the base substrate 100.

Fig. 13 is a schematic diagram of a partial cross-sectional structure cut along line EE' shown in Fig. 6 according to another example of an embodiment of the present disclosure. The display substrate in the example shown in Fig. 13 differs from the display substrate in the example shown in Fig. 12 in that depths of the grooves 620 in the planarization layers 600 are different. Fig. 13 does not show a film layer between the planarization layer 600 and the base substrate 100. For the film layer disposed between the planarization layer 600 and the base substrate 100 in Fig. 13, reference may be made to the film layer disposed between the planarization layer 600 and the base substrate 100 shown in Fig. 12.

For example, as shown in Fig. 13, at least one part of the surface of the light emitting functional layer 230 away from the base substrate 100 may be closer to the base substrate 100 than the surface of the electrode overlapping portion 520 away from the base substrate 100. For example, at least some film layers of a plurality of film layers included in the light emitting functional layer 230 are closer to the base substrate 100 than the electrode overlapping portion 520. For example, at least one part that is of the second electrode 220 and that is in the groove 620 is closer to the base substrate 100 than the electrode overlapping portion 520.

For example, as shown in Fig. 13, in the direction perpendicular to the base substrate 100, the opening 310 of the pixel defining pattern overlaps the groove 620. For example, at least one part of an orthographic projection of the optical conversion layer 240 on the planarization layer 600 is located in the groove 620. For example, the orthographic projection of the optical conversion layer 240 on the planarization layer 600 is completely located in the groove 620.

For example, the maximum thickness of the defining portion 320 in the display substrate provided in the example shown in Fig. 13 may be less than the maximum thickness of the defining portion 320 in the display substrate provided in the examples shown in Fig. 7 to Fig. 12.

In an example of this embodiment of the present disclosure, the groove is provided in the planarization layer, and the surface on the side that is of at least some film layers of the light emitting functional layer away from the base substrate is set to be closer to the base substrate than the surface of the electrode overlapping portion away from the base substrate, so that when the optical conversion layer is completely located in the opening defined by the defining portion, the height of the defining portion is reduced as much as possible, so as to increase continuity of the second electrode.

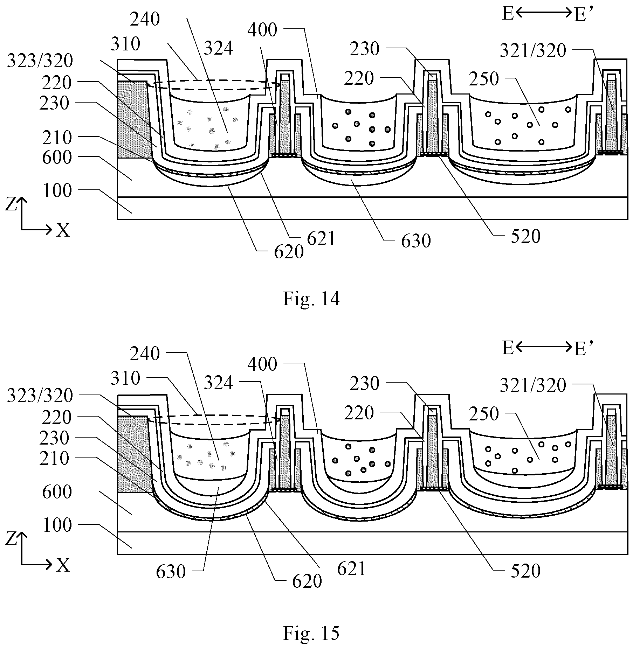

Fig. 14 and Fig. 15 are schematic diagrams of partial cross-sectional structures cut along line EE' shown in Fig. 6 according to different examples of an embodiment of the present disclosure. The display substrate in the examples shown in Fig. 14 and Fig. 15 differs from the display substrate in the example shown in Fig. 13 in that a transparent compensation structure 630 is disposed in the groove 620 of the planarization layer 600. The display substrates in the examples shown in Fig. 14 and Fig. 15 differ from each other in that the positions of the transparent compensation structures 630 are different. Structures such as the base substrate, the first insulation layer, the light emitting functional layer, the pixel defining pattern, and the first electrode in the display substrate shown in Fig. 14 and Fig. 15 may have the same features as structures such as the base substrate, the first insulation layer, the light emitting functional layer, the pixel defining pattern, and the first electrode in the display substrate shown in Fig. 13. Details are not described herein again.

In some examples, as shown in Fig. 14 and Fig. 15, the display substrate further includes the transparent compensation structure 630, located between the optical conversion layer 240 and the bottom of the groove 620.

In the display substrate provided in this example, the transparent compensation structure is filled between the groove and the optical conversion layer, so as to enable, to the greatest extent, the optical conversion layer to be formed on a relatively flat surface, thereby improving flatness of the optical conversion layer formed in the groove, and improving the display effect.

For example, as shown in Fig. 14, the transparent compensation structure 630 may be located between the first electrode 210 and the planarization layer 600.

For example, as shown in Fig. 15, the transparent compensation structure 630 may be located between the optical conversion layer 240 and the second electrode 210.

For example, as shown in Fig. 15, the transparent compensation structure 630 may be some film layers in the first insulation layer 400. For example, the first insulation layer 400 may be an encapsulation layer. A thickness of a part of the encapsulation layer located in the groove 620 is greater than a thickness of a part of the encapsulation layer located at position outside the groove 620. For example, the encapsulation layer located in the groove 620 may include an organic encapsulation layer.

For example, the transparent compensation structure 630 may alternatively be a lens.

Certainly, this embodiment of the present disclosure is not limited to filling the transparent compensation structure in the groove, to improve flatness of the middle part in the optical conversion layer. Alternatively, the optical conversion layer may be formed through layering, to improve flatness of the middle part in the optical conversion layer.

In some examples, as shown in Fig. 13 to Fig. 15, a side wall 621 of the groove 620 is obliquely disposed, and the side wall includes a part away from the base substrate 100 and a part close to the base substrate 100, the part away from the base substrate 100 is farther away from a center of a light emitting region of the light emitting element disposed in the groove 620 than the part close to the base substrate 100. For example, the side wall of the groove 620 is oblique toward the outer side. The outer side is a side of the center of the light emitting element surrounded by the groove and that points to the edge.

For example, a pattern that is of the side wall 621 of the groove 620 and that is cut by a plane (for example, the XZ plane) perpendicular to the base substrate 100 may be a straight line, or may be a curved line.

In an example of this embodiment of the present disclosure, the side wall of the groove in the planarization layer is obliquely disposed, to help improve light extracting efficiency of the entire surface.

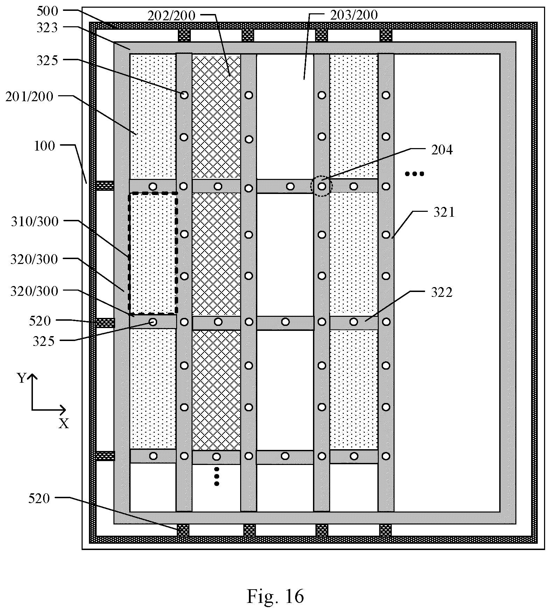

Fig. 16 to Fig. 17B are schematic diagrams of partial planar structures of display substrates according to different examples of an embodiment of the present disclosure. The display substrate in the examples shown in Fig. 16 to Fig. 17B differs from the display substrate in the example shown in Fig. 6 in that the defining portion 320 in the display substrate shown in Fig. 16 to Fig. 17B includes holes 325. For example, the second electrode of the light emitting element may be electrically connected to the electrode overlapping portion 520 through a plurality of holes 325. The display substrates in the examples shown in Fig. 16 to Fig. 17B differ from each other in that shapes of the light emitting regions of the light emitting elements are different. Features of the base substrate, the defining portion, the light emitting element, and the like in the display substrate in the examples shown in Fig. 16 to Fig. 17B may be the same as features of the base substrate, the defining portion, the light emitting element, and the like in the display substrate in the foregoing example. Details are not described herein again.

For example, as shown in Fig. 16 to Fig. 17B, the electrode overlapping portion 520 may be disposed only at a position corresponding to the hole 325, or the electrode overlapping portion 520 extending in the same direction as the defining portion 320 may be disposed.

In the display substrate provided in this embodiment of the present disclosure, a plurality of holes is provided in the defining portion, so that when the effect of the electrical connection between the second electrode and the electrode overlapping portion is improved, the problem that the first electrode is short-circuited at a position at which the second electrode is connected to the electrode overlapping portion or the problem of electric leakage can be avoided to the greatest extent.

For example, in at least some of the holes 325, a center of an overlapping portion of the second electrode 220 and the electrode overlapping portion 520 does not overlap the center of hole 325. For example, in at least some of the holes 325, the area of the overlapping portion of the second electrode 220 and the electrode overlapping portion 520 is less than the area of an orthographic projection of the hole 325 on the electrode overlapping portion 520.

For example, as shown in Fig. 16, the holes 325 arranged in the row direction may be arranged at equal spacings, and the holes 325 arranged in the row direction are located on a same straight line. The holes 325 arranged in the column direction may also be arranged at equal spacings, and the holes 325 arranged in the column direction may be located on a same straight line.

For example, spacings between the holes 325 arranged in the row direction may be the same as spacings between the holes 325 arranged in the column direction.

For example, some of the holes 325 may be blind holes. To be specific, the light emitting functional layer in the hole 325 is not removed, and the second electrode is not connected with the electrode overlapping portion at a position of the blind hole. The blind holes are provided to help improve process efficiency.

In some examples, as shown in Fig. 16 to Fig. 17A, a spacing with a largest size in spacings between light emitting regions of adjacent light emitting elements 200 of different colors and spacings between adjacent light emitting elements 200 of a same color overlaps the hole 325.

For example, as shown in Fig. 16 to Fig. 17A, the spacing 204 with the largest size between light emitting regions exists between columns in which first light emitting elements 201 and third light emitting elements 203 adjacent to each other are located. The hole 325 is provided at the spacing 204, which is beneficial to avoiding the problem short circuit or electric leakage between the first electrode and the position at which the second electrode is connected to the electrode overlapping portion.

The foregoing "column" means that a plurality of first light emitting elements arranged in the Y direction are one column, a plurality of second light emitting elements arranged in the Y direction are one column, and a plurality of third light emitting elements arranged in the Y direction are one column.

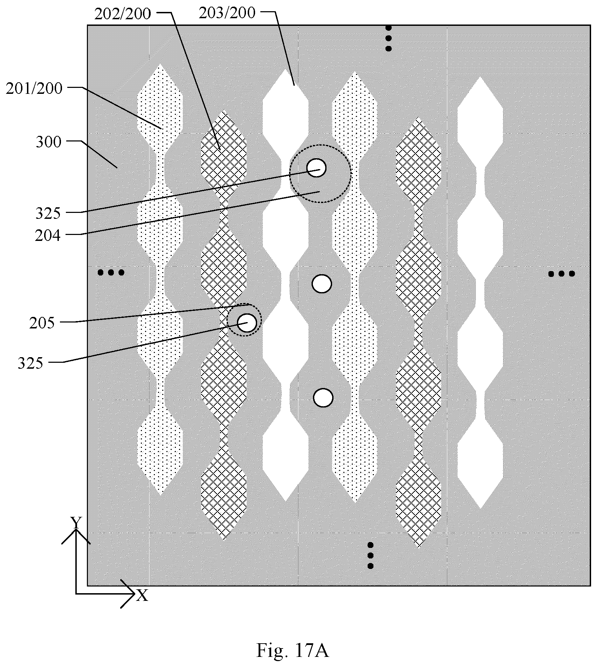

Certainly, this embodiment of the present disclosure is not limited thereto. For example, as shown in Fig. 17A, the hole 325 may also be provided at a position of a spacing 205 with the largest size between the column in which the third light emitting elements 203 are located and the column in which the second light emitting elements 202 are located. For example, the maximum size of the spacing 205 is less than the maximum size of the spacing 204.

For example, as shown in Fig. 16 to Fig. 17A, the hole 325 may be provided between adjacent light emitting elements of different colors. For example, the hole 325 may also be provided between adjacent light emitting elements of a same color. For example, the hole 325 may be provided at a position of a spacing with the largest size between light emitting regions of adjacent light emitting elements of a same color. For example, the hole 325 may be provided at a position of a spacing with the smallest size between light emitting regions of adjacent light emitting elements of different colors.

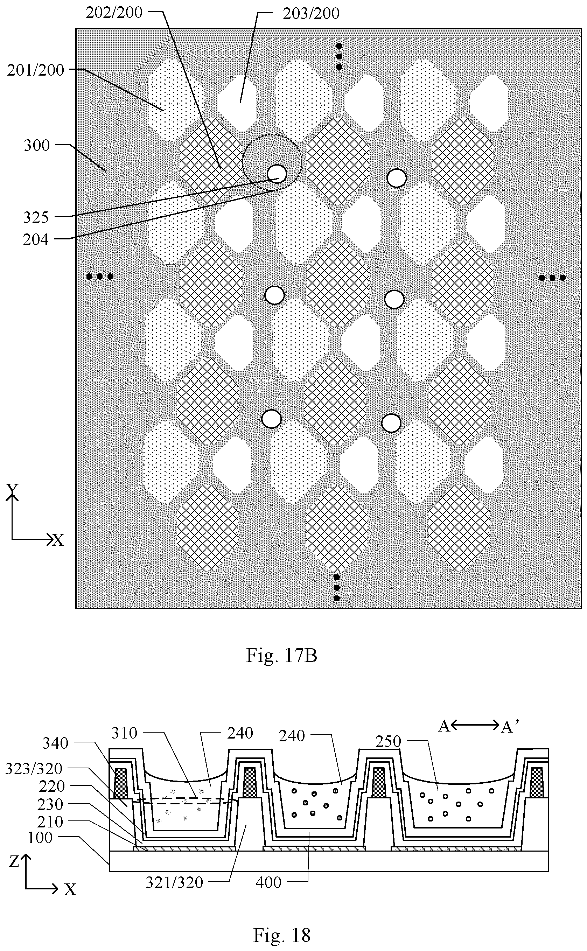

For example, as shown in Fig. 17B, the first light emitting element 201 may be a red light emitting element, the second light emitting element 202 may be a green light emitting element, and the third light emitting element 203 may be a blue light emitting element. For example, a shape of a light emitting region of the green light emitting element 202 may be a hexagon or an octagon. For example, the shape of the light emitting region of the green light emitting element 202 may be a symmetric figure, for example, the symmetry axis extends in the Y direction. For example, the shape of the light emitting region of at least one of the blue light emitting element 203 and the red light emitting element 201 may be an octagon. For example, the light emitting region of at least one of the blue light emitting element 203 and the red light emitting element 201 may be an asymmetric figure in the Y direction. For example, the plurality of light emitting elements 200 may be arranged into two sub-light emitting element rows. One of the sub-light emitting element rows includes red light emitting elements 201 and blue light emitting elements 203 that are arranged alternately in the row direction (for example, the X direction), and the other of the sub-light emitting element rows includes green light emitting elements 202 arranged in the row direction. In the row direction, a distance between light emitting regions of two adjacent green light emitting elements 202 is greater than a distance between light emitting regions of the blue light emitting element 203 and the red light emitting element 201 that are adjacent to each other. The hole 325 is provided between light emitting regions of two adjacent green light emitting elements 202 in the row direction. For example, at least one of the distance between light emitting regions of adjacent red light emitting elements 201 arranged in the column direction (for example, the Y direction) and the distance between light emitting regions of adjacent blue light emitting elements 203 arranged in the column direction is greater than the distance between the light emitting regions of adjacent green light emitting elements 202 arranged in the column direction. The hole 325 may be provided between light emitting regions of adjacent red light emitting elements 201 arranged in the column direction.

Fig. 18 is a schematic diagram of a partial cross-sectional structure cut along line AA' shown in Fig. 1A according to another example of an embodiment of the present disclosure. The display substrate in the example shown in Fig. 18 differs from the display substrate in the example shown in Fig. 2 in that, the display substrate further includes a spacer (PS) 340, located on a surface of at least one part of the defining portion 320 away from the base substrate 100.

For example, the spacer 340 is located between the defining portion 320 and the second electrode 220. For example, the spacer 340 is configured to support an evaporation mask for manufacturing the light emitting functional layer.

For example, an orthographic projection of the spacer 340 on the base substrate 100 is completely located within an orthographic projection of the defining portion 320 on the base substrate 100.

For example, as shown in Fig. 18, the surface of the optical conversion layer 240 away from the base substrate 100 is farther away from the base substrate 100 than the surface of the defining portion 320 away from the base substrate 100. For example, the surface of the optical conversion layer 240 away from the base substrate 100 is closer to the base substrate 100 than the surface of the spacer 340 away from the base substrate 100.

By disposing the spacer on the surface of the defining portion away from the base substrate, the opening formed by the spacer may be used to define the optical conversion layer, and the maximum thickness of the defining portion of the pixel defining pattern is set to be less than the thickness of the optical conversion layer, which is beneficial to improving continuity of the second electrode.

For example, in the pixel defining pattern, the maximum thickness of the first sub-defining portion is basically the same as the maximum thickness of the second sub-defining portion. For example, the spacer 340 is disposed only on the surfaces of the first sub-defining portion 321 and the annular defining portion 323 away from the base substrate 100, and no spacer 340 is disposed on the surface of the second sub-defining portion 322 away from the base substrate 100.

For example, the slot in the example shown in Fig. 6 may be provided at a position at which no spacer 340 is disposed in the defining portion 320. For example, a slot may be provided at the position at which no spacer 340 is disposed in the first sub-defining portion 321, to enable the second electrode 220 to be electrically connected to the electrode overlapping portion.

For example, a size of the spacer 340 in the direction parallel to the base substrate 100 is less than a size of the defining portion 320 in the direction, to help improve continuity of the second electrode formed on the defining portion and the spacer.

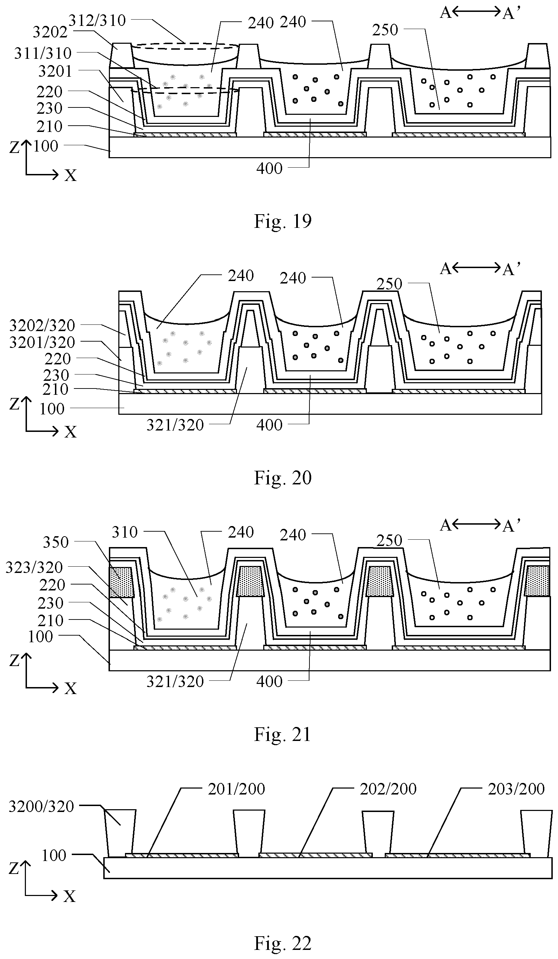

Fig. 19 is a schematic diagram of a partial cross-sectional structure cut along line AA' shown in Fig. 1A according to another example of an embodiment of the present disclosure. The display substrate in the example shown in Fig. 19 differs from the display substrate in the example shown in Fig. 2 in that, the defining portion 320 includes a first defining portion 3201 and a second defining portion 3202 that are stacked, the first defining portion 3201 is located on a side of the second defining portion 3202 close to the base substrate 100, and the surface of the optical conversion layer 240 close to the base substrate 100 is closer to the base substrate 100 than the surface of at least one part of the second defining portion 3202 away from the base substrate 100. Structures such as the light emitting element, the base substrate, and the first insulation layer in the display substrate provided in this example may have the same features as structures such as the light emitting element, the base substrate, and the first insulation layer in the display substrate in any of the examples shown in Fig. 2 to Fig. 17A. Details are not described herein again.

For example, as shown in Fig. 19, the surface of the first defining portion 3201 away from the base substrate 100 is closer to the base substrate 100 than the surface of the optical conversion layer 240 away from the base substrate 100, and the surface of the second defining portion 3202 away from the base substrate 100 is farther away from the base substrate 100 than the surface of the optical conversion layer 240 away from the base substrate 100. An opening 311 defined by the first defining portion 3201 may be used to define the light emitting functional layer 230, and an opening 312 defined by the second defining portion 3202 may be used to define the optical conversion layer 240.

In the display substrate provided in this example, the defining portion is set to include the first defining portion and the second defining portion that are stacked, to help increase the overall thickness of the defining portion, so as to form the opening region used to define the optical conversion layer. This facilitates flexible setting of the thickness of the optical conversion layer.

For example, the maximum size of an orthographic projection of the opening 311 defined by the first defining portion 3201 on the base substrate 100 may be less than the maximum size of an orthographic projection of the opening 312 defined by the second defining portion 3202 on the base substrate 100. Certainly, this embodiment of the present disclosure is not limited thereto. The maximum size of the orthographic projection of the opening 311 on the base substrate 100 may alternatively be greater than or equal to the maximum size of the orthographic projection of the opening 312 on the base substrate 100.

For example, as shown in Fig. 19, in the direction perpendicular to the base substrate 100, the maximum size of the first defining portion 3201 may be greater than the maximum size of the second defining portion 3202.

In some examples, as shown in Fig. 19, the first insulation layer 400 is disposed between the first defining portion 3201 and the second defining portion 3202. For example, the second electrode 220 is further disposed between the first defining portion 3201 and the second defining portion 3202. For example, the light emitting functional layer 230 is further disposed between the first defining portion 3201 and the second defining portion 3202.

In this example, the defining portion is set to include the first defining portion and the second defining portion that are stacked, and the first insulation layer, for example, the encapsulation layer, is disposed between the first defining portion and the second defining portion, so that when the overall thickness of the defining portion is relatively large to form the opening that defines the optical conversion layer, the thickness of the first defining portion can be set to be relatively small, so as to improve continuity of the second electrode formed on the first defining portion.

For example, Fig. 19 schematically shows that the thickness of the first defining portion 3201 is greater than the thickness of the second defining portion 3202, but this embodiment is not limited thereto. The thickness of the first defining portion may be less than the thickness of the second defining portion, to further improve continuity of the second electrode formed on the first defining portion.

For example, the defining portion shown in Fig. 19 may include the first sub-defining portion and the second sub-defining portion with different thicknesses in the examples shown in Fig. 2 and Fig. 3, or include the first sub-defining portion and the second sub-defining portion in the example shown in Fig. 5, or include the slot and the electrode overlapping portion disposed opposite to the slot shown in Fig. 6, or include the hole and the electrode overlapping portion disposed opposite to the hole in Fig. 16, or include the spacer shown in Fig. 18. This is not limited in this example.

For example, the surface of the planarization layer in the display substrate shown in Fig. 19 away from the base substrate may be a flat surface, or include the groove in the planarization layer shown in any one of Fig. 12 to Fig. 15, or include the planarization layer convex portion shown in Fig. 11.

Fig. 20 is a schematic diagram of a partial cross-sectional structure cut along line AA' shown in Fig. 1A according to another example of an embodiment of the present disclosure. The display substrate in the example shown in Fig. 20 differs from the display substrate in the example shown in Fig. 19 in that the first defining portion 3201 is in direct contact with the second defining portion 3202. Structures such as the light emitting element, the base substrate, and the first insulation layer in the display substrate provided in this example may have the same features as structures such as the light emitting element, the base substrate, and the first insulation layer in the display substrate in any of the examples shown in Fig. 2 to Fig. 17A. Details are not described herein again.

In some examples, as shown in Fig. 20, the defining portion 320 includes at least two layers of structures of stacked structures. Fig. 20 schematically shows that the defining portion 320 includes two layers of structures, but this embodiment is not limited thereto. The defining portion may further include three layers of structures or more layers of structures that are stacked. For example, any two adjacent layers in a plurality of layers of structures included in the defining portion are in direct contact, or a layer of structure that is in the plurality of layers included in the defining portion and that is farthest away from the base substrate is located on a side of the first insulation layer away from the base substrate, or at least two layers of structures in the plurality of layers included in the defining portion are located on a side of the first insulation layer away from the base substrate.

For example, as shown in Fig. 20, the first insulation layer 400 is located on a side of the second defining portion 3202 away from the first defining portion 3201. For example, the second electrode 220 is located on a side of the second defining portion 3202 away from the first defining portion 3201.

For example, as shown in Fig. 20, in the direction perpendicular to the base substrate 100, the maximum size of the first defining portion 3201 may be greater than the maximum size of the second defining portion 3202, but this embodiment is not limited thereto. In the direction perpendicular to the base substrate, the size of the first defining portion may alternatively be less than or equal to the maximum size of the second defining portion.

For example, as shown in Fig. 20, a slope angle of a slope formed by the surface of the second defining portion 3202 away from the base substrate 100 may be less than a slope angle of a slope formed by the surface of the first defining portion 3201 away from the base substrate 100, to improve continuity of the second electrode formed on the second defining portion.

For example, the first defining portion disposed in a stacked manner shown in Fig. 20 may include the slot shown in Fig. 11, and the second defining portion may not overlap the slot. For example, a same first defining portion may include two slots to form three parts, the second defining portion is disposed on the middle part of the first defining portion, and there is no second defining portion on the part on either side of the first defining portion, so that the second defining portion can expose the slot.

For example, as shown in Fig. 20, shapes of cross sections that of the first defining portion 3201 and the second defining portion 3202 and that are cut by the plane perpendicular to the base substrate 100, for example, the XZ plane, may be the same, for example, both are trapeziums. In addition, a bottom that is of the trapezium away from the base substrate 100 is an upper bottom, and a bottom that is of the trapezium and that is close to the base substrate 100 is a lower bottom. A length of the lower bottom is greater than a length of the upper bottom. However, this embodiment of the present disclosure is not limited thereto. The shapes of the cross sections that of the first defining portion and the second defining portion and that are cut by the plane perpendicular to the base substrate may be different. For example, the cross-sectional shape of one of the first defining portion and the second defining portion is a trapezium, and the cross-sectional shape of the other is a rectangle. For example, the shape of the first defining portion is a step shape, and the shape of the second defining portion is a trapezium, a rectangle, a triangle, an arc, or the like. Cross-sectional shapes of the first defining portion and the second defining portion are not limited in this embodiment of the present disclosure.

For example, a cross section that is of the second defining portion 3202 and that is cut by the plane perpendicular to the base substrate 100 may be a trapezium, and an angle between an oblique side and a lower bottom of the trapezium is relatively small, for example, not greater than 45 degrees. This facilitates increasing a ratio of the maximum opening defining the light emitting functional layer to the maximum opening defining the optical conversion layer.

For example, the materials of the first defining portion 3201 and the second defining portion 3202 may be the same or may be different.

For example, in two surfaces that are of the first defining portion 3201 and the second defining portion 3202 and that are in contact with each other, the maximum size of the surface of the first defining portion 3201 in the direction parallel to the base substrate 100 may be less than the maximum size of the surface of the second defining portion 3202 in the direction parallel to the base substrate 100, to form an undercutting structure.

Fig. 21 is a schematic diagram of a partial cross-sectional structure cut along line AA' shown in Fig. 1A according to another example of an embodiment of the present disclosure. The display substrate in the example shown in Fig. 21 differs from the display substrate in the example shown in Fig. 2 in that the display substrate further includes an insulation structure 350, located between the second electrode 220 and the defining portion 320. Structures such as the light emitting element, the base substrate, and the first insulation layer in the display substrate provided in this example may have the same features as structures such as the light emitting element, the base substrate, and the first insulation layer in any of the examples shown in Fig. 2 to Fig. 17A. Details are not described herein again.

In some examples, as shown in Fig. 21, in the direction perpendicular to the base substrate 100, the isolation structure 350 overlaps the defining portion 320, and materials of the isolation structure 350 and the defining portion 320 are different. In an arrangement direction of adjacent light emitting elements, an edge of the isolation structure 350 located between the adjacent light emitting elements protrudes relative to an edge of the defining portion 320, to form a convex portion.

For example, the material of the isolation structure 350 includes an inorganic non-metallic material. For example, the material of the isolation structure 350 may include any one or more of: silicon nitride, silicon oxide, and silicon oxynitride.

For example, the shape of the isolation structure 350 may be set, to make the light emitting functional layer 230 disconnected at the convex portion, and the second electrode 220 is continuously disposed at the convex portion. For example, a ratio of a thickness sum of the isolation structure 350 and the defining portion 320 to the thickness of the light emitting functional layer 230 is 0.7 to 1.5. For example, a slope angle between a side surface of at least one part of the isolation structure 350 and the plane parallel to the base substrate 100 is greater than 60 degrees. For example, in the direction parallel to the base substrate 100, the size of the convex portion is not less than 0.01 micron. For example, a surface of the isolation structure 350 away from the base substrate 100 is a bent surface that is bent toward the base substrate 100.

For example, as shown in Fig. 21, the surface of the optical conversion layer 240 away from the base substrate 100 is farther away from the base substrate 100 than the surface of the defining portion 320 away from the base substrate 100. For example, the surface of the optical conversion layer 240 away from the base substrate 100 is closer to the base substrate 100 than the surface of the isolation structure 350 away from the base substrate 100.

By disposing the isolation structure on the surface of the defining portion away from the base substrate, the opening region formed by the isolation structure may be used to define the optical conversion layer, and the maximum thickness of the defining portion of the pixel defining pattern is set to be less than the thickness of the optical conversion layer, which is beneficial to improving continuity of the second electrode.

For example, the maximum thickness of the first sub-defining portion is basically the same as the maximum thickness of the second sub-defining portion in the pixel defining pattern. For example, the isolation structure 350 is disposed only on the surfaces of the first sub-defining portion 321 and the annular defining portion 323 away from the base substrate 100, and no isolation structure 350 is disposed on the surface of the second sub-defining portion 322 away from the base substrate 100.

For example, the slot 324 shown in Fig. 6 may be provided in the defining portion 320 and the isolation structure 350, to enable the second electrode 220 to be electrically connected to the electrode overlapping portion.

For example, a size of the isolation structure 350 in the direction parallel to the base substrate 100 is less than a size of the defining portion 320 in the direction, to help improve continuity of the second electrode formed on the defining portion and the spacer.

Fig. 22 to Fig. 26 are schematic diagrams of partial cross-sectional structures of defining portions in display substrates according to different examples. For example, as shown in Fig. 22 to Fig. 26, the defining portion 320 may be a structure with one layer. Certainly, this embodiment of the present disclosure is not limited thereto. The defining portion may further include a plurality of layers of stacked structures of any one of the shapes in Fig. 22 to Fig. 26.

In some examples, as shown in Fig. 22 to Fig. 26, a cross section of the defining portion 320 cut by a plane is a defining portion cross section 3200, the plane is a plane where a line connecting centers of light emitting regions of two adjacent light emitting elements 200 located on two sides of the defining portion 320 is located. A shape of the defining portion cross section 3200 includes a trapezium, a step shape, or the like, and the plane is perpendicular to the base substrate 100. For example, the plane may be the XZ plane.

For example, as shown in Fig. 22, the shape of the defining portion cross section 3200 may be a trapezium, and an upper bottom of the trapezium is closer to the base substrate 100 than a lower bottom, for example, an inverted trapezium. For example, a size of the surface of the defining portion 320 away from the base substrate 100 in the X direction is greater than a size of the surface of the defining portion 320 close to the base substrate 100 in the X direction. By forming the shape of the defining portion cross section into the inverted trapezium, the size of the maximum opening defining the light emitting functional layer can be greater than the size of the maximum opening defining the optical conversion layer, to avoid color contamination of light of different colors. For example, to further avoid color contamination, a reflecting layer or reflecting particles may be further disposed on a side surface of the defining portion or inside the defining portion.

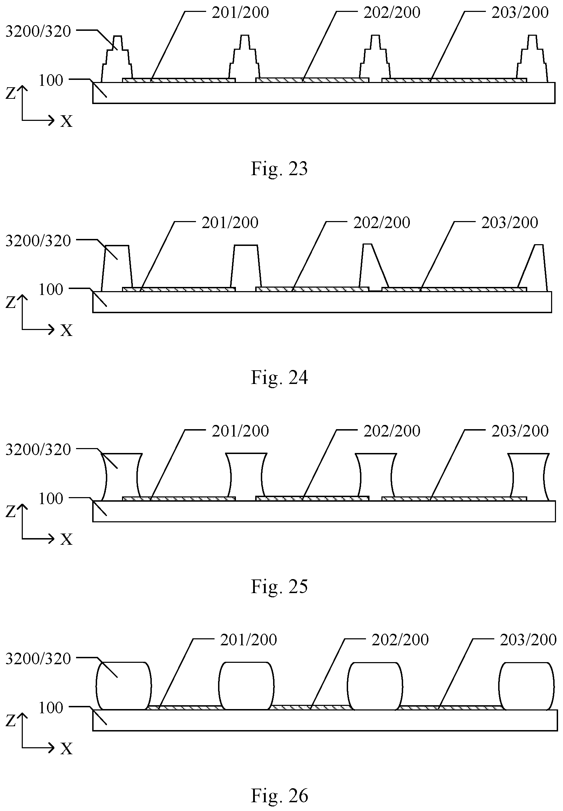

For example, as shown in Fig. 23, the shape of the defining portion cross section 3200 may be a step shape. By forming the shape of the defining portion cross section into the step shape, the size of the maximum opening defining the light emitting functional layer can be less than the size of the maximum opening defining the optical conversion layer, to enable light emitted by the light emitting element to be incident onto the optical conversion layer in a maximum range.

For example, as shown in Fig. 24, the shape of the defining portion cross section 3200 may be a trapezium, and an upper bottom of the trapezium is farther away from the base substrate 100 than a lower bottom. For example, the size of the surface of the defining portion 320 away from the base substrate 100 in the X direction is less than the size of the surface of the defining portion 320 and that is close to the base substrate 100 in the X direction.

For example, as shown in Fig. 24, defining portion cross sections 3200 of the defining portion 320 define light emitting regions of different light emitting elements 200 have different shapes. For example, an angle between an oblique side that is of the defining portion cross section 3200 defining the third light emitting element 203 facing the light emitting region of the third light emitting element 203 and the plane parallel to the base substrate 100 is less than an angle between an oblique side that is of the defining portion cross section 3200 away from the light emitting region of the third light emitting element 203. This facilitates adjusting a light exit angle and light extracting efficiency of light emitting elements of different colors.

For example, the third light emitting element 203 may be the blue light emitting element, the red light emitting element, or the green light emitting element.

In some examples, as shown in Fig. 25 and Fig. 26, a cross section of the defining portion 320 cut by a plane is a defining portion cross section 3200, the plane is a plane where a line connecting centers of light emitting regions of two adjacent light emitting elements 200 located on two sides of the defining portion 320 is located. A size of a middle part of the defining portion cross section 3200 in the direction parallel to the base substrate 100 is greater than or less than a size of a part on either side in the direction parallel to the base substrate 100. The plane is perpendicular to the base substrate 100. For example, the plane may be the XZ plane.

For example, as shown in Fig. 25, the defining portion cross section 3200 of the defining portion 320 may be a structure in which the middle part is concave inward.

For example, as shown in Fig. 26, the defining portion cross section 3200 of the defining portion 320 may be a structure in which the middle part is convex outward.

For example, the defining portion of any one of the shapes shown in Fig. 22 to Fig. 26 may include the first sub-defining portion and the second sub-defining portion with different thicknesses in the examples shown in Fig. 2 and Fig. 3, or include the first sub-defining portion and the second sub-defining portion in the example shown in Fig. 5, or include the slot and the electrode overlapping portion disposed opposite to the slot shown in Fig. 6, or include the hole and the electrode overlapping portion disposed opposite to the hole in Fig. 16, or include the spacer shown in Fig. 18. This is not limited in this example.

For example, the surface of the planarization layer in the display substrate shown in Fig. 22 to Fig. 26 away from the base substrate may be a flat surface, or include the groove in the planarization layer shown in any one of Fig. 12 to Fig. 15, or include the planarization layer convex portion shown in Fig. 11.

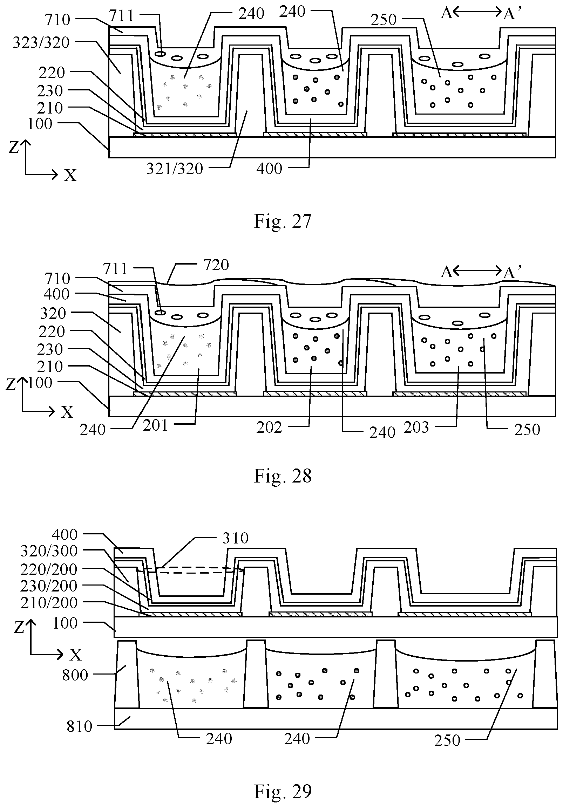

Fig. 27 is a schematic diagram of a partial cross-sectional structure cut along line AA' shown in Fig. 1A according to another example of an embodiment of the present disclosure. The display substrate in the example shown in Fig. 27 differs from the display substrate in the example shown in Fig. 2 in that, the display substrate further includes a second insulation layer 710, located on the side of the optical conversion layer 240 away from the base substrate 100.

For example, the second insulation layer 710 may be an encapsulation layer for encapsulating the optical conversion layer 240.

In some examples, as shown in Fig. 27, the second insulation layer 710 includes refractive particles 711. For example, the material of the refractive particle 711 may include zirconia.

The second insulation layer including the refractive particles is disposed on the light exit side of the optical conversion layer, it is beneficial to improving light extracting efficiency.

Structures such as the pixel defining pattern, the light emitting element, the base substrate, and the first insulation layer in the display substrate shown in Fig. 27 may have the same features as structures such as the pixel defining pattern, the light emitting element, the base substrate, and the first insulation layer in any of the examples shown in Fig. 2 to Fig. 26. Details are not described herein again.

Fig. 28 is a schematic diagram of a partial cross-sectional structure cut along line AA' shown in Fig. 1A according to another example of an embodiment of the present disclosure. The display substrate in the example shown in Fig. 28 differs from the display substrate in the example shown in Fig. 27 in that the display substrate further includes a color film layer 720, located on a side of the second insulation layer 710 away from the optical conversion layer 240.

For example, as shown in Fig. 28, the color film layer 720 includes a part located in a light emitting region and a part located in an adjacent light emitting region. For example, the first light emitting element 201 may be a red light emitting element, and a color film that is in the color film layer 720 and that corresponds to the first light emitting element 201 may be a red color film. The second light emitting element 202 may be a green light emitting element, and a color film that is in the color film layer 720 and that corresponds to the second light emitting element 202 may be a green color film. The third light emitting element 203 may be a blue light emitting element, and a material that is in the color film layer 720 and that corresponds to the third light emitting element 203 may be a blue color film.

For example, color film layers 720 disposed on the defining portion 320 between light emitting regions of adjacent light emitting elements may be stacked to implement an optical filtering function. For example, stack layers of the red color film and the green color film are disposed on the defining portion 320 between light emitting regions of the first light emitting element 201 and the second light emitting element 202. Stack layers of the green color film and the blue color film are disposed on the defining portion 320 between light emitting regions of the second light emitting element 202 and the third light emitting element 203.

For example, the color film layer shown in Fig. 28 may use a COE (Color On Encapsulation) technology, to form a color film on the encapsulation layer, thereby increasing a contrast ratio of the display apparatus.

For example, as shown in Fig. 28, after the second insulation layer 710 is formed on the optical conversion layer 240, a groove is formed at a position corresponding to the optical conversion layer 240. The groove directly faces the opening of the pixel defining pattern. The color film layer 720 includes a part formed in the groove. For example, a surface of the color film layer 720 close to the base substrate 100 may be a flat surface, and at least one part of a surface of the color film layer 720 away from the base substrate may be a surface concave toward the base substrate 100.

Certainly, this embodiment of the present disclosure is not limited thereto. A cover plate may be disposed on a display side of the display substrate. The color film layer may also be disposed on a side of the cover plate facing the display substrate.

Fig. 29 shows a display substrate according to another embodiment of the present disclosure. As shown in Fig. 29, the display substrate includes a base substrate 100 and a plurality of light emitting elements 200 and a pixel defining pattern 300 that are located on the base substrate 100. The light emitting element 200 includes a light emitting functional layer 230 and a first electrode 210 and a second electrode 220 that are located on two sides of the light emitting functional layer 230 in the direction perpendicular to the base substrate 100, and the first electrode 210 is located between the light emitting functional layer 230 and the base substrate 100. The pixel defining pattern 300 is located on a side of the first electrode 210 away from the base substrate 100. The pixel defining pattern 300 includes a plurality of openings 310 and a defining portion 320 that surrounds the plurality of openings 310, and the light emitting element 200 is at least partially located in the opening 310. At least one of the light emitting elements 200 further includes the optical conversion layer 240, the optical conversion layer 240 is configured such that light of one color is incident to the optical conversion layer and then exits light of another color, and the optical conversion layer 240 is located on a side of the first electrode 210 away from the second electrode 220.

In the display substrate provided in this embodiment of the present disclosure, the optical conversion layer is disposed on the side of the first electrode away from the second electrode, to minimize the distance between the optical conversion layer and the light emitting functional layer, thereby improving conversion efficiency of the optical conversion layer for incident light.

For example, the light emitting functional layer 230 in the display substrate shown in Fig. 29 may have the same features as the light emitting functional layer 230 in the display substrate shown in Fig. 1A. Details are not described herein again.

For example, in the display substrate displayed in Fig. 29, the first electrode 210 of the light emitting element 200 is a transparent electrode, and the second electrode 220 of the light emitting element 200 is a reflective electrode. For example, light emitted by the light emitting functional layer 230 is reflected by the second electrode 220 toward a side of the first electrode 210 away from the second electrode 220, for emission after passing through the optical conversion layer 240.

For example, the maximum size, for example, the thickness of the defining portion in the display substrate shown in Fig. 29 in the direction perpendicular to the base substrate 100 may be set to be relatively small, to define the region formed by the light emitting functional layer of the light emitting element. In the display substrate, the thickness of the defining portion is set to be relatively small, to help improve continuity of the second electrode.

For example, as shown in Fig. 29, the optical conversion layer 240 is located on a side of the base substrate 100 away from the first electrode 210.

For example, the optical conversion layer 240 and the light transmissive functional layer 250 in the display substrate shown in Fig. 29 may have the same features as the optical conversion layer 240 and the light transmissive functional layer 250 in the display substrate shown in Fig. 1A to Fig. 2. Details are not described herein again.

For example, as shown in Fig. 29, a separation structure 800 is disposed on a side of the base substrate 100 away from the first electrode 210, to define positions of the optical conversion layer 240 and the light transmissive functional layer 250.

For example, as shown in Fig. 29, an orthographic projection of the separation structure 800 on the base substrate 100 overlaps an orthographic projection of the defining portion 320 on the base substrate 100.

For example, as shown in Fig. 29, an opening region formed by the separation structure 800 is used to form the optical conversion layer 240 and the light transmissive functional layer 250.

For example, the defining portion 320 in the display substrate shown in Fig. 29 may be set to include the first sub-defining portion and the second sub-defining portion with different thicknesses in the examples shown in Fig. 2 and Fig. 3, or include the first sub-defining portion and the second sub-defining portion in the example shown in Fig. 5, or include the slot and the electrode overlapping portion disposed opposite to the slot shown in Fig. 6, or include the hole and the electrode overlapping portion disposed opposite to the hole in Fig. 16.

For example, the display substrate shown in Fig. 29 may include the planarization layer shown in Fig. 10 to Fig. 15.

For example, as shown in Fig. 29, a base 810 is disposed on the side of the optical conversion layer 240 away from the base substrate 100. For example, a surface of the optical conversion layer 240 away from the base substrate 100 may be a flat surface, and a surface of the optical conversion layer 240 close to the base substrate 100 may be a surface concave toward the side away from the base substrate 100.

For example, a color film layer may be disposed between the optical conversion layer 240 and the base 810.

For example, as shown in Fig. 29, the display substrate further includes a first insulation layer 400 located on a side of the second electrode 220 away from the base substrate 100. The first insulation layer 400 may be an encapsulation layer. The encapsulation layer may include an organic encapsulation layer and an inorganic encapsulation layer that are stacked.

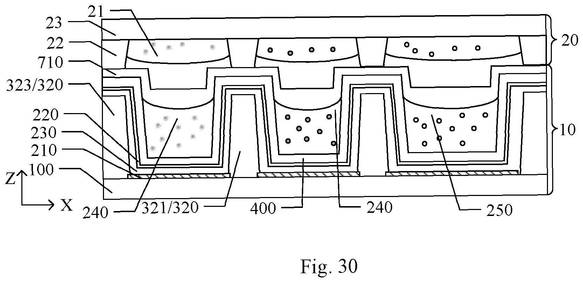

Fig. 30 is a schematic diagram of a partial cross-sectional structure of a display apparatus according to another embodiment of the present disclosure. As shown in Fig. 30, the display apparatus includes the display substrate 10 shown in any one of the examples as mentioned above. Fig. 30 schematically shows that the display apparatus includes the display substrate shown in Fig. 2. However, this embodiment is not limited thereto. The display apparatus may further include any one of the display substrates shown in Fig. 4A to Fig. 29. As shown in Fig. 30, the display apparatus further includes an opposing substrate 20 disposed opposite to the display substrate 10. The opposing substrate 20 is located on a display side of the display substrate 10.

For example, as shown in Fig. 30, light emitted by the light emitting element is emitted from a side of the second electrode 220 away from the base substrate 100, and the opposing substrate 20 is located on the side that is of the second electrode 220 away from the base substrate 100. However, this embodiment is not limited thereto. When light emitted by the light emitting element is emitted from the side of the base substrate away from the second electrode, the opposing substrate is located on the side of the base substrate away from the second electrode.

In some examples, as shown in Fig. 30, a material layer 20 is disposed on a side of the opposing substrate 20 facing the display substrate 10 and at a position directly opposite the optical conversion layer 240, and the material layer 21 includes the same material as that in the optical conversion layer 240.

Disposing the material layer with the same material as the optical conversion layer on the opposing substrate facilitates reducing the thickness of the opposing substrate and improves optical conversion efficiency.

For example, as shown in Fig. 30, the opposing substrate 20 may include a cover plate 23, and a separation structure 22 located on a side of the cover plate 21 facing the display substrate 10. The material layer 21 is defined by an opening formed by the separation structure 22.

For example, the display apparatus further includes a color film layer (not shown in the figure). The color film layer may be disposed on a side of the material layer away from the display substrate.

For example, the display apparatus provided in this embodiment of the present disclosure may be an organic light emitting diode display apparatus.

For example, the display apparatus may be any product or component having a display function, for example, a mobile phone having an under-display camera, a tablet computer, a notebook computer, or a navigator. This embodiment is not limited thereto.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate;
a plurality of light emitting elements, located on the base substrate, wherein the light emitting element comprises a light emitting functional layer, and a first electrode and a second electrode that are located on two sides of the light emitting functional layer in a direction perpendicular to the base substrate, and the first electrode is located between the light emitting functional layer and the base substrate; and
a pixel defining pattern, located on a side of the first electrode away from the base substrate, wherein the pixel defining pattern comprises a plurality of openings and a defining portion that surrounds the plurality of openings, and the light emitting elements are at least partially located in the openings,
wherein at least one light emitting element further comprises an optical conversion layer, the optical conversion layer is configured such that light of one color is incident to the optical conversion layer and then exits light of another color, the optical conversion layer is located on a side of the second electrode away from the base substrate, and at least a part of the optical conversion layer is located in the opening, and the optical conversion layer has a part in the opening, a surface, of the part of the optical conversion layer, close to the base substrate is closer to the base substrate than a surface, of at least one part of the defining portion, away from the base substrate.

2. The display substrate according to claim 1, wherein a surface, of the part of the optical conversion layer, away from the base substrate is closer to the base substrate than the surface, of the at least one part of the defining portion, away from the base substrate.

3. The display substrate according to claim 1 or 2, wherein a surface, of the part of the optical conversion layer, away from the base substrate comprises a central part and an edge part, the central part is closer to the base substrate than the edge part.

4. The display substrate according to any one of claims 1 to 3, wherein the optical conversion layer comprises quantum dots.

5. The display substrate according to any one of claims 1 to 4, further comprising:
a first insulation layer, located between the optical conversion layer and the second electrode,
wherein the first insulation layer has a part located in the opening, a surface, of the part of the first insulation layer, away from the base substrate is closer to the base substrate than the surface, of the at least one part of the defining portion, away from the base substrate.

6. The display substrate according to claim 5, wherein a thickness of the first insulation layer is less than a thickness of the at least one part of the defining portion.

7. The display substrate according to claim 5 or 6, wherein the first insulation layer comprises at least two film layers, and a difference between thicknesses of different film layers is less than one micron.

8. The display substrate according to any one of claims 1 to 7, wherein the plurality of light emitting elements comprises light emitting elements of at least two colors, the defining portion located between openings corresponding to adjacent light emitting elements of different colors comprises a first sub-defining portion, the defining portion located between openings corresponding to adjacent light emitting elements of a same color comprises a second sub-defining portion, a maximum thickness of the first sub-defining portion is greater than a maximum thickness of the second sub-defining portion, and/or, a surface of the first sub-defining portion away from the base substrate comprises a first slope, a surface of the second sub-defining portion away from the base substrate comprises a second slope, and a slope angle of the first slope is greater than a slope angle of the second slope; and
a part of the second electrode covering the second sub-defining portion is continuously disposed.

9. The display substrate according to claim 8, further comprising:
a signal transmission line, located on a side of the first electrode facing the base substrate; and
a transmission portion, located on the side of the first electrode facing the base substrate, and electrically connected to the signal transmission line, wherein
the display substrate comprises a display region and a peripheral region that surrounds the display region, the signal transmission line is located in the peripheral region, the transmission portion is located on a side that is of a part on an utmost edge in the defining portion and that is close to the display region, and the second electrode is electrically connected to the transmission portion.

10. The display substrate according to claim 8 or 9, wherein at least two adjacent light emitting elements arranged in a first direction emit light of a same color, and at least two adjacent light emitting elements arranged in a second direction emit light of different colors, and the first direction intersects with the second direction; and
the defining portion comprises a plurality of first sub-defining portions and a plurality of second sub-defining portions, at least one of the first sub-defining portions extends in the first direction, and the second sub-defining portion extending in the second direction is disposed between two adjacent first sub-defining portions.

11. The display substrate according to any one of claims 1 to 7, further comprising:
an electrode overlapping portion, located on a side of the defining portion facing the base substrate, wherein the defining portion overlaps the electrode overlapping portion in a direction perpendicular to the base substrate,
wherein the defining portion comprises a hole or a slot exposing the electrode overlapping portion, and the second electrode is electrically connected to the electrode overlapping portion via the hole or the slot.

12. The display substrate according to claim 11, wherein a ratio of a maximum thickness of the defining portion between light emitting elements that emit light of different colors to a maximum thickness of the defining portion between light emitting elements that emit light of a same color is 0.8 to 1.

13. The display substrate according to claim 12, wherein at least one part of the electrode overlapping portion and at least one part of the defining portion extend in a same direction.

14. The display substrate according to any one of claims 11 to 13, further comprising:
a signal transmission line, located on a side of the first electrode facing the base substrate, wherein the display substrate comprises a display region and a peripheral region that surrounds the display region, the signal transmission line is located in the peripheral region, and the second electrode is electrically connected to the signal transmission line by using the electrode overlapping portion.

15. The display substrate according to any one of claims 11 to 14, wherein the electrode overlapping portion comprises at least one film layer disposed at the same layer as the first electrode.

16. The display substrate according to claim 15, wherein the electrode overlapping portion comprises a plurality of film layers, and a distance between a surface of the electrode overlapping portion away from the base substrate and the base substrate is greater than a distance between a surface of the first electrode away from the base substrate and the base substrate.

17. The display substrate according to any one of claims 11 to 15, wherein the electrode overlapping portion comprises a film layer located on the side of the first electrode away from the base substrate.

18. The display substrate according to any one of claims 11 to 17, further comprising:
a planarization layer, located between the first electrode and the base substrate,
wherein the planarization layer comprises a planarization layer convex portion, and an orthographic projection of the planarization layer convex portion on the base substrate overlaps an orthographic projection of the electrode overlapping portion on the base substrate, so that a distance between a surface of the electrode overlapping portion away from the base substrate and the base substrate is greater than a distance between a surface of the first electrode away from the base substrate and the base substrate.

19. The display substrate according to any one of claims 11 to 17, further comprising:
a planarization layer, located between the first electrode and the base substrate,
wherein the planarization layer comprises a groove, and the defining portion does not overlap the groove in the direction perpendicular to the base substrate; and
the first electrode and the light emitting functional layer of at least some of the light emitting elements are located in the groove, and at least one part of a surface of the light emitting functional layer away from the base substrate is closer to the base substrate than a surface of the electrode overlapping portion away from the base substrate.

20. The display substrate according to claim 19, further comprising:
a transparent compensation structure, located between the optical conversion layer and a bottom of the groove.

21. The display substrate according to claim 19 or 20, wherein a side wall of the groove is obliquely disposed, and the side wall comprises a part away from the base substrate and a part close to the base substrate, the part away from the base substrate is farther away from a center of a light emitting region of the light emitting element disposed in the groove than the part close to the base substrate.

22. The display substrate according to claim 11, wherein the defining portion comprises the hole, the plurality of light emitting elements comprises light emitting elements of at least two different colors, and among a spacing between light emitting regions of adjacent light emitting elements with different colors and a spacing between adjacent light emitting elements with a same color, at least the spacing with a largest size is provided with the hole.

23. The display substrate according to any one of claims 1 to 4, further comprising:
an isolation structure, located between the second electrode and the defining portion, wherein the isolation structure overlaps the defining portion in the direction perpendicular to the base substrate, and a material of the isolation structure is different from a material of the defining portion; and
in an arrangement direction of adjacent light emitting elements, an edge, of the isolation structure located between the adjacent light emitting elements, protrudes relative to an edge of the defining portion to form a convex portion.

24. The display substrate according to any one of claims 1 to 22, further comprising:
a spacer, located on a surface of at least one part in the defining portion away from the base substrate.

25. The display substrate according to any one of claims 1 to 4, wherein the defining portion comprises a first defining portion and a second defining portion that are stacked, the first defining portion is located on a side of the second defining portion close to the base substrate, and a surface of the optical conversion layer close to the base substrate is closer to the base substrate than a surface of at least one part of the second defining portion away from the base substrate.

26. The display substrate according to claim 25, wherein the first defining portion is in direct contact with the second defining portion; or,
the display substrate further comprises a first insulation layer, located between the optical conversion layer and the second electrode, wherein the first insulation layer is disposed between the first defining portion and the second defining portion.

27. The display substrate according to claim 1, wherein a cross section of the defining portion cut by a plane is a defining portion cross section, the plane is a plane where a line connecting centers of light emitting regions of two adjacent light emitting elements located on both sides of the defining portion is located, a shape of the defining portion cross section comprises a trapezium or a step shape, and the plane is perpendicular to the base substrate.

28. The display substrate according to claim 1, wherein a cross section of the defining portion cut by a plane is a defining portion cross section, the plane is a plane where a line connecting centers of light emitting regions of two adjacent light emitting elements located on both sides of the defining portion is located, the defining portion cross section comprises a middle part and two side parts, in a direction parallel to the base substrate, a size of the middle part is greater than or less than sizes of the two side parts, and the plane is perpendicular to the base substrate.

29. The display substrate according to claim 1, wherein the defining portion comprises at least two layers of structures that are stacked.

30. The display substrate according to claim 1, wherein the light emitting functional layer comprises a thermally activated delayed fluorescent material.

31. The display substrate according to claim 30, wherein the plurality of light emitting elements comprises light emitting elements of at least two colors, the light emitting functional layers of the light emitting elements of the at least two colors are configured to both emit first color light, and the light emitting element of at least one color in the light emitting elements of the at least two colors comprises the optical conversion layer, and the first color light is converted to second color light after passing through the optical conversion layer.

32. The display substrate according to any one of claims 1 to 31, further comprising:
a second insulation layer, located on a side of the optical conversion layer away from the base substrate; and
a color film layer, located on a side of the second insulation layer away from the optical conversion layer.

33. The display substrate according to claim 32, wherein the second insulation layer comprises refractive particles.

34. A display substrate, comprising:
a base substrate;
a plurality of light emitting elements, located on the base substrate, wherein the light emitting element comprises a light emitting functional layer, and a first electrode and a second electrode that are located on two sides of the light emitting functional layer in a direction perpendicular to the base substrate, and the first electrode is located between the light emitting functional layer and the base substrate; and
a pixel defining pattern, located on a side of the first electrode away from the base substrate, wherein the pixel defining pattern comprises a plurality of openings and a defining portion that surrounds the plurality of openings, and the light emitting element is at least partially located in the opening,
wherein at least one of the light emitting elements further comprises an optical conversion layer, the optical conversion layer is configured such that light of one color is incident to the optical conversion layer and then exits light of another color, and the optical conversion layer is located on a side of the first electrode away from the second electrode.

35. A display apparatus, comprising the display substrate according to any one of claims 1 to 34 and an opposing substrate disposed opposite to the display substrate, wherein the opposing substrate is located on a display side of the display substrate.

36. The display apparatus according to claim 35, wherein a material layer is disposed on a side of the opposing substrate facing the display substrate and at a position directly opposite the optical conversion layer, and the material layer comprises the same material as that in the optical conversion layer.
